# EUROPEAN PATENT SPECIFICATION

(11) **EP 2 803 707 B1**
(45) Date of publication and mention of the grant of the patent: **23.12.2015**
(21) Application number: 13736153.1
(22) Date of filing: 08.01.2013
(51) Int. Cl.: C09D 183/14, C09D 7/12, G02B 1/10, G02B 5/02, H01L 51/50, H05B 33/02

(54) **COATING COMPOSITION, POROUS FILM, LIGHT-SCATTERING FILM, AND ORGANIC ELECTROLUMINESCENT ELEMENT**
BESCHICHTUNGSZUSAMMENSETZUNG, PORÖSER FILM, LICHTSTREUUNGSFOLIE UND ORGANISCHES ELEKTROLUMINESZENTES ELEMENT
COMPOSITION DE REVÊTEMENT, FILM POREUX, FILM DE DIFFUSION DE LUMIÈRE, ET ÉLÉMENT ÉLECTROLUMINESCENT ORGANIQUE

(30) Priority: 10.01.2012 JP 2012001989
(43) Date of publication of application: 19.11.2014
(73) Proprietor: Mitsubishi Chemical Corporation, Chiyoda-ku Tokyo 100-8251 (JP)
(72) Inventor: UMEMOTO Tomokazu, Yokohama-shi Kanagawa 227-8502 (JP)
(74) Representative: Ter Meer Steinmeister & Partner
(86) International application number: PCT/JP2013/050135
(87) International publication number: WO 2013/105556

(56) References cited:
- JP-A- H0 978 060
- JP-A- H1 021 527
- JP-A- 2000 265 116
- JP-A- 2000 294 374
- JP-A- 2001 281 421
- JP-A- 2003 053 195
- JP-A- 2003 133 306
- JP-A- 2006 022 314
- JP-A- 2006 199 854
- JP-A- 2006 199 854
- JP-A- 2007 131 714

## Description

### Technical Field

The present invention relates to a coating composition, a porous membrane and a light scattering membrane obtained by applying the coating composition, and an organic electroluminescent element having the light scattering membrane.

### Background Art

An organic electroluminescent element (hereinafter sometimes referred to as "organic EL") is composed of a constitution containing a positive electrode and a negative electrode on a glass substrate and a light-emitting layer formed between the both electrodes. A light emitted in the light-emitting layer by electrification between the both electrodes is extracted outside with passing through the positive electrode (e.g.,
a transparent electrode such as ITO) and the glass substrate. However, since reflection caused by a difference in refractive index is generated at interfaces between ITO and the glass substrate and between the glass substrate and the air, most part of the emitted light cannot be extracted outside and it is known that the light extracted outside is about 20% of the emitted light.

In order to improve light extraction efficiency of the organic electroluminescent element, an attempt of providing a scattering layer between the transparent electrode such as ITO that is an electrode and the glass substrate has been reported.

For example, Patent Document 1 reports a scattering layer in which gas bubbles are included in a glass medium by using an ink obtained by kneading glass frits (powder) together with a resin, applying the ink on the glass substrate, and baking and heating it at high temperature to thereby melt the glass frits and also burn the resin.

Moreover, Patent Document 2 reports a scattering layer obtained by applying an acrylic resin solution containing zinc oxide as scattering particles by spin coating.

Furthermore, Patent Document 3 reports that a cured film obtained by applying a mixture of a sol-gel solution that is a hydrolyzate of tetraethoxysilane and a silica sol solution having a particle diameter of 80 nm by spin coating and heating it at 300°C is used as a scattering layer.

Document JP-A- 2006 022314 describes a coating composition used for the preparation of membranes comprising a polysilane compound and silica particles treated with a surface treatment agent having a hydrophobic group. The coating composition further comprises an organic solvent such as toluene. The films are used as hard coat film, antireflective film and interlayer insulation film for silicon wafer, used in semiconductor element, liquid crystal display, plasma display and lens. The compositions do not comprise metal oxide particles having a refractive index of 2.0 or more and do not comprise compounds having a carbamate functionality

Document JP-A- H09 78060 relates to an electroluminescent element comprising a light-emitting layer between a pair of electrodes. The light-emitting layer contains a coating composition comprising a polymer selected from among polysilane, polygermane, polystannane and their copolymer. The coating composition may further comprise a metal oxide, metal hydroxide or metal. The compositions do not comprise compounds having a carbamate structure.

Document JP-A- 2006 199854 describes membranes having a low refractive index characterized by comprising silica particles, a polysilane and a solvent. The coating is used for reducing reflection in surfaces of a display. The compositions do not contain compounds having a carbamate structure nor metal oxide particles having a refractive index of 2.0 nor more.

Document JP-A- 2003 053195 discloses a flexible photocatalyst device used for UV rays or visible light and for the manufacture of an organic EL light emitting element in which the light emitting layer containing a composition comprising a polysilane and titanium oxide particles. The compositions do not comprise solvent and compounds with carbamate functionality.

Document JP-A- 2000 294374 relates to a method for producing a polarized luminous electroluminescent device. The composition does not contain any metal oxide particles and is free of compound with carbamate functionality.

### Prior Art Documents

### Patent Documents

Patent Document 1: WO2009/116531
Patent Document 2: JP-A-2010-182449
Patent Document 3: WO2003/26357

### Summary of the Invention

### Problems that the Invention is to Solve

However, since the scattering layer described in Patent Document 1 is formed by melting glass frits, it is necessary to perform baking at a temperature of 500C or more, so that there is a problem in productivity in view of large consumption of heat energy and necessity of a high-temperature baking furnace. Moreover, since baking at high temperature becomes necessary, there is a problem that a plastic material is not applicable as a substrate, so that the layer is poor in versatility. Furthermore, since the scattering membrane is composed of an inorganic glass material, flexibility is considered to be low and there is a problem that the membrane is not applicable to a flexible substrate material represented by a super-thin sheet glass or a plastic film (hereinafter referred to as "flexible substrate material").

The scattering layer described in Patent Document 2 is formed by applying a resin solution by spin coating. From the viewpoint that the scattering layer can be formed by drying at a temperature of around boiling point of the solvent after the application, the layer is preferable due to low consumption of heat energy. However, the scattering membrane formed contains an organic resin as a main component, so that heat-resistant temperature is low. Accordingly, there arises a problem at the time when it is used as a substrate for electronic devices which pass through a process in which temperature change is large. Furthermore, refractive index of an organic resin is generally as low as a level of 1.5 to 1.6. Thus, for example, at the time of use as an organic EL substrate, total reflection of an emitted light at the interface with an adjacent high-refractive body ITO membrane (refractive index: 1.9) is still large and an improvement in light extraction efficiency becomes insufficient.

The scattering layer described in Patent Document 3 is formed by applying a sol-gel solution of a metal alkoxide. Similarly to Patent Document 2, the method can be said to be a preferable method from the viewpoint that it is an easy formation method by application and a membrane having a high heat resistance can be obtained. However, the cured film formed from the sol-gel solution of a metal alkoxide generates cracks owing to shrinkage stress at curing when the thickness increases. An effective thickness at which cracks are not generated is 200 nm or less (Sumio Sakka, Hyomen Gijutsu (Surface Technology), No. 57, 2006) and, in order to introduce scattering particles having a particle diameter of several tens nm or more, which are effective for visual light scattering, into the effective thickness, an amount thereof is limited, so that the function as a light scattering membrane may be poor in some cases. Moreover, there is a problem that the scattering membrane has a low flexibility since it is composed of an inorganic glass material and thus it is not applicable to a flexible substrate material.

An object of the invention is to provide a coating composition capable of being easily formed by application or the like and is to provide a porous membrane, a light scattering membrane, and an organic electroluminescent element which are excellent in heat resistance, surface smoothness and flexibility and have a high refractive index, a high light scattering property and a high light transmittance.

### Means for Solving the Problems

As a result of extensive studies in consideration of the above problems, the present inventors have found that voids are formed inside a cured product obtained by curing a composition containing a polysilane, a metal oxide, a solvent and a compound having a carbamate structure. Since the porous cured product in which voids are formed has a light scattering property, they have found that the cured product can be applicable as a light scattering membrane, and thus have accomplished the present invention.

Namely, the invention is as follows.
[1] A coating composition comprising a polysilane compound, a metal oxide, a solvent and a compound having a carbamate structure.
[2] The coating composition according to the above [1], wherein the compound having a carbamate structure is a dispersing agent.
[3] The coating composition according to any one of the above [1] and [2], wherein the metal oxide is at least one selected from zinc oxide, titanium oxide, barium titanate, tantalum oxide, silicon oxide, aluminum oxide, zirconium oxide, cerium oxide, and tin oxide.
[4] The coating composition according to any one of the above [1] to [3], wherein a refractive index of the metal oxide is 2.0 or more.
[5] The coating composition according to any one of the above [1] to [4], wherein an average particle diameter of the metal oxide is 1,000 µm or less.
[6] The coating composition according to any one of the above [1] to [5], wherein the polysilane compound is a silicon network polymer represented by the general formula (2):

   (R²Si)ₙ (2)

   wherein R² is the same or different from each other and represents a hydrogen atom, an alkyl group, an alkenyl group, an arylalkyl group, an aryl group, an alkoxy group, a hydroxyl group, a phenolic hydroxyl group, or an amino group; n is an integer of 4 to 10000.
[7] A porous membrane obtained by curing the coating composition according to any one of the above [1] to [6].
[8] A light scattering membrane obtained by curing the coating composition according to any one of the above [1] to [6].
[9] An organic electroluminescent element comprising the light scattering membrane according to the above [8].
[10] The organic electroluminescent element according to the above [9], wherein the light scattering membrane is arranged between a substrate and a positive electrode.
[11] The organic electroluminescent element according to the above [10], wherein the substrate is a flexible substrate having flexibility.
[12] An organic EL display device comprising the organic electroluminescent element according to any one of the above [9] to [11].
[13] An organic EL lighting comprising the organic electroluminescent element according to any one of the above [9] to [11].
[14] A method for manufacturing a porous membrane, the method comprising: applying the coating composition according to any one of the above [1] to [6] on a substrate; and removing the solvent.

### Advantage of the Invention

According to the invention, a light scattering layer can be formed by a simple and convenient method such as application. Moreover, the light scattering layer obtained is excellent in heat resistance, has a high refractive index, is excellent in surface smoothness, and has a high light scattering property and a high light transmittance.

### Brief Description of the Drawings

[Fig. 1] Fig. 1 is a photograph showing a SEM image (10,000 magnifications) of the surface of the scattering layer 1.
[Fig. 2] Fig. 2 is a photograph showing a SEM image (30,000 magnifications) of the surface of the scattering layer 1.
[Fig. 3] Fig. 3 is a photograph showing a SEM image (10,000 magnifications) of the surface of the scattering layer 16.
[Fig. 4] Fig. 4 is a photograph showing a SEM image (10,000 magnifications) of the surface of the scattering layer 17.
[Fig. 5] Fig. 5 is a schematic view showing one example of the constitution of the organic electroluminescent element.
[Fig. 6] Fig. 6 is a schematic view showing one example of the constitution of the organic electroluminescent element.

### Modes for Carrying Out the Invention

The following will explain the present invention in detail.

### I. Coating Composition

The coating composition of the invention comprises a polysilane compound, a metal oxide, a a solvent and a compound having a carbamate structure (1) Polysilane Compound

A polysilane compound is a general term for compounds having a silicon (Si)-silicon (Si) bond as shown below and has a high refractive index and is excellent in visual light transparency since a σ bond is delocalized on the Si-Si bond main chain. The polysilane compound to be used in the invention is not particularly limited so long as it is a linear, cyclic, or network-like compound having the Si-Si bond, which is exemplified below.

### (1)-1: Linear Polysilane Compound and Cyclic Polysilane Compound

(R¹₂Si)ₘ (1)

wherein R¹ represents a hydrogen atom, an alkyl group, an alkenyl group, an arylalkyl group, an aryl group, an alkoxy group, a hydroxyl group, a phenolic hydroxyl group, or an amino group; R¹ may be all the same or any combination of the substituents described above; and m is an integer of 2 to 10,000.

### (1)-2: Silicon Network Polymer

(R²Si)ₙ (2)

wherein R² is the same or different from each other and represents a hydrogen atom, an alkyl group, an alkenyl group, an arylalkyl group, an aryl group, an alkoxy group, a hydroxyl group, a phenolic hydroxyl group, or an amino group; n is an integer of 4 to 10,000.

### (1)-3: Network-like Polymer

(R³₂Si)ₓ(R³Si)_{y}Si_{z} (3)

wherein R³ represents a hydrogen atom, an alkyl group, an alkenyl group, an arylalkyl group, an aryl group, an alkoxy group, a hydroxyl group, a phenolic hydroxyl group, or an amino group; R³ may be all the same or any combination of the substituents described above; and x, y and z are each an integer of 0 or more, the sum of x, y and z is from 5 to 10,000, and a case where any two of x, y and z are 0 is excluded.

The above polymers can be, for example, manufactured by, using monomer(s) having each structural unit as raw material(s), a method of dehalogenative polycondensation of halosilane(s) in the presence of an alkali metal ("Kipping method" J. Am. Chem. Soc., 110, 124 (1988), Macromolecules, 23, 3423 (1990)), a method of dehalogenative polycondensation of halosilane(s) by electroreduction (J. Chem. Soc., Chem. Commun., 1161 (1990), J. Chem. Soc., Chem. Commun., 897 (1992)), a method of dehydrogenative polycondensation of hydrosilane(s) in the presence of a metal catalyst (JP-A-4-334551), a method of anionic polymerization of disilene(s) crosslinked by biphenyl or the like (Macromolecules, 23, 4494 (1990)), a method of ring-opening polymerization of cyclic silane(s), and similar methods.

As the linear polysilane compound and the cyclic polysilane compound represented by the general formula (1), R¹ is the same or different from each other and is preferably a hydrogen atom, an alkyl group, an alkenyl group, an arylalkyl group, an aryl group, an alkoxy group, or a hydroxyl group, particularly preferably a hydrogen atom, an alkyl group, an aryl group, an alkoxy group, or a hydroxyl group. Moreover, m is preferably from 2 to 300, particularly preferably from 4 to 150. For example, methylphenylpolysilane having an average polymerization degree of 4 to 150 is preferable.

As the silicon network polymer represented by the general formula (2), R² is the same or different from each other and is preferably a hydrogen atom, an alkyl group, an alkenyl group, an arylalkyl group, an aryl group, an alkoxy group, or a hydroxyl group, more preferably a hydrogen atom, an alkyl group, an aryl group, an alkoxy group, or a hydroxyl group. Furthermore, it is particularly preferable that R² is composed of an alkyl group and a phenyl group and the alkyl group is a methyl group and the aryl group is a phenyl group. Moreover, n is preferably from 4 to 300, particularly preferably from 4 to 150. For example, phenyl network polysilane having an average polymerization degree of 4 to 150 is preferable.

As the network-like polymer having an Si-Si bond as a skeleton represented by the general formula (3), R³ is the same or different from each other and is preferably a hydrogen atom, an alkyl group, an alkenyl group, an arylalkyl group, an aryl group, an alkoxy group, or a hydroxyl group, more preferably a hydrogen atom, an alkyl group, an aryl group, an alkoxy group, or a hydroxyl group. Furthermore, it is particularly preferable that R³ is composed of an aryl group, and the aryl group is composed of a phenyl group. Moreover, x, y and z are preferably from 1 to 300, from 1 to 300 and from 1 to 50, respectively.

In view of having a high heat resistance, it is preferable to use the polymer of the general formula (2) or the general formula (3) as a structure of the polysilane compound.

As preferable polysilane compounds, for example, there may be mentioned OGSOL SI-10-10, SI-10-20, SI-20-10, SI-20-10 (improved), SI-30-10, and the like. Of these, it is more preferable to use SI-20-10 (improved).

Incidentally, SI-20-10 (improved) is a methylphenylpolysilane compound (methyl group:phenyl group=about 1:3 in molar ratio) having a weight-average molecular weight (Mw) of 1,200 and a number-average molecular weight (Mn) of 900 (GPC: in terms of polystyrene), having a heat resistant temperature of 354°C (5% weight loss), and having a terminal hydroxyl group.

The above methylphenylpolysilane has a low phenyl group ratio and it is surmised that voids are more easily formed. A ratio of the methyl group to the phenyl group (molar ratio) of the methylphenylpolysilane compound is 1:9 or less, preferably 1:5 or less, more preferably 1:3 or less.

In the invention, the above polysilane compound may be used singly or two or more kinds thereof may be used in combination. Moreover, even in the case where two or more kinds of the polysilane compound are used in combination, the mixing ratio thereof is not particularly limited and can be arbitrarily selected.

### (2) Metal Oxide

### - Kind of Metal Oxide

The coating composition of the invention contains metal oxide particles as the metal oxide. The metal oxide particles are suitably used in view of a high heat resistance.

As such metal oxide particles, there may be mentioned zinc oxide, titanium oxide, silicon oxide, aluminum oxide, zirconium oxide, cerium oxide, tin oxide, tantalum oxide, copper oxide, silver oxide, iron oxide, bismuth oxide, tungsten oxide, indium oxide, manganese oxide, vanadium oxide, niobium oxide, strontium titanate, barium titanate, indium-tin oxide (ITO), aluminum-zinc oxide (AZO), gallium-zinc oxide (GZO), and the like.

These are all known compounds and are easily available. Moreover, raw materials thereof and methods for manufacturing the same, and the like are not particularly limited. At that time, the metal oxide particles may be surface-treated. As method for the surface treatment, for example, there may be mentioned a method of adsorbing a surface-treating agent on the metal oxide particles by adding the surface-treating agent to a powder of the metal oxide particles and mixing them by means of a ball mil, a bead mill, a kneader or the like or using a heat treatment in combination, a method of chemically bonding the agent to the particles, and the like. As chemical species to be introduced by the surface treatment, for example, there may be mentioned inorganic oxides such as aluminum hydroxide, silica and zirconium oxide, organic acids such as stearic acid, inorganic acids such as phosphoric acid, basic chemical species such as ammonia and amines, silicones, and the like.

In the invention, the metal oxide particles may be singly mixed into the composition or two or more kinds thereof may be mixed thereinto. The mixing ratio is not particularly limited and may be arbitrarily selected. Moreover, at the time of mixing, the metal oxide particles may be mixed as a powder or may be mixed as a dispersion after the particles are dispersed in a suitable solvent.

The metal oxide particles are preferably composed of zinc oxide, titanium oxide, barium titanate, tantalum oxide, silicon oxide, aluminum oxide, zirconium oxide, cerium oxide, and tin oxide. The reason is that absorption of visual light is small and a high visual light transmittance is obtained.

The refractive index of the metal oxide is more preferably 2.0 or more. In the case where it is used as a scattering membrane for enhancing light extraction efficiency in an organic electroluminescent element, the reason is that, when the membrane has a refractive index higher than that of the adjacent high refractive ITO membrane (refractive index: about 1.9), light loss caused by total reflection at the interface is not generated. As metal oxides having a refractive index of 2.0 or more, for example, there may be mentioned titanium oxide, zinc oxide, cerium oxide, barium titanate, zirconium oxide, tantalum oxide, tungsten oxide, tin oxide, indium oxide, and the like.

### - Particle Diameter

In general, fine particles are classified into primary particles that are considered to be unit particles judged from apparent geometrical form and secondary particles in which plural pieces of the primary particles are aggregated. The particles of the invention may be either the primary particles or the secondary particles. The average particle diameter of the metal oxide particles is 1,000 nm or less, preferably 700 nm or less, further preferably 500 nm or less. By using the metal oxide particles having an average particle diameter falling within such a range, a scattering membrane having excellent light scattering property, light transparency, and surface smoothness can be obtained. Incidentally, the average particle diameter of the metal oxide particles can be measured by a dynamic light scattering method in the case of a dispersion. In the case of a light scattering membrane obtained by curing, the diameter can be calculated from the size of particles on an image photographed by an electron microscope or the like.

As these metal oxide particles, for example, there may be mentioned utilization of a zinc oxide particle dispersion "NANOBYK3821" (primary particle diameter: 20 nm), "NANOBYK3841" (primary particle diameter: 40 nm), "NANOBYK3842" (primary particle diameter: 40 nm), a silicon oxide particle dispersion "NANOBYK3650" (primary particle diameter: 20 nm), an alumina particle dispersion "NANOBYK3601" (primary particle diameter: 40 nm), a cesium oxide particle dispersion "NANOBYK3812" (primary particle diameter: 10 nm), manufactured by BYK Japan KK; a zirconium oxide particle dispersion "ZRPMA15WT%-E05" (primary particle diameter: 20 nm), "ZEMIBK15WT%-F57" (primary particle diameter: 10 nm), a titanium oxide particle dispersion "PTIMA30WT%-N01" (primary particle diameter: 250 nm), manufactured by CIK Nano Tec KK; "ITO Nano Metal Ink ITO1 Cden" manufactured by ULVAC Material KK; "ITO Nano Particles" (standard particle diameter: 15 to 25 nm), "ITO Nano Particles" (single nano particle diameter: 5 to 10 nm), "ITO Nano Particles" (large nano particle diameter: 80 to 100 nm), manufactured by Tomoe Seisakusyo KK; ITO nano particles "Nano Disper ITO (SP2)" (primary particle diameter: 5 to 15 nm) manufactured by Okuno Chemical industries Co., Ltd.; TiO2 nano particles "PST18NR" (primary particle diameter: 18 nm), "PST400C" (primary particle diameter: 400 nm) manufactured by JGC Catalysts and Chemicals Ltd.; "Solanix T" (primary particle diameter: 10 nm), "Solanix D20" (primary particle diameter: 20 nm) manufactured by Solarnix; a titanium oxide powder "TTO-55" (primary particle diameter: 30 to 50 nm), "TTO-51" (primary particle diameter: 10 to 30 nm) manufactured by Ishihara Sangyo Kaisha, Ltd.; "Cerium Oxide" powder manufactured by Musashino Denshi Kogyo; "Tantalum Oxide" powder manufactured by Kojundo Chemical Laboratory Co., Ltd.; and the like.

### (3) Solvent

The solvent contained in the coating composition of the invention is not particularly limited so long as the polysilane compound and the metal oxide are dispersed or dissolved therein and are applicable. Examples thereof include aromatic solvents such as toluene, xylene, and anisole; ethers such as tetrahydrofuran and propylene glycol monomethyl ether; ketones such as methyl ethyl ketone, methyl isobutyl ketone, and cyclohexanone; esters such as propylene glycol monomethyl ether acetate, cellosolve acetate, and ethyl lactate; halogenated hydrocarbons such as dichloromethane and monochlorobenzene; heterocycles such as N-methylpyrrolidone; and the like. They may be used singly or may be used as a mixed solvent of two or more thereof.

In the invention, the coating composition further comprises a compound having a carbamate structure (hereinafter referred to as a "carbamate compound").

### (4) Carbamate Compound

The coating composition of the invention is characterized in that voids are formed inside the cured product obtained by curing. Although the mechanism of forming the voids is not revealed, it is surmised that a mixture of the metal oxide particles and the polysilane compound is aggregated and combined along with phase separation thereof from the solvent to form the voids in the process of drying and removing the solvent. At that time, the carbamate compound (so-called compound having a urethane bond) in the composition has an effect of promoting the formation of the voids. The carbamate compound in the composition generates decomposition gases such as carbon dioxide and nitrogen through thermal decomposition in the process of heat curing, and it is considered that the decomposition gases are included as gas bubbles in the composition during curing to thereby contribute the formation of the voids.

When a cross-section of the cured product is observed on a scanning electron microscope, fine particles are sometimes confirmed at an outer peripheral part of the voids. When the fine particles are subjected to EDX (energy dispersive X-ray spectroscopy) analysis, C (carbon) element has been detected as a main component. It is considered that the fine particles of carbon are formed by carbonization of some organic substances through thermal decomposition, and the particles support a possibility of participation of the generation of the decomposition gases in the mechanism of the void formation.

The carbamate compound is preferably contained in the composition as a dispersing agent. At the time of a dispersion treatment for obtaining a dispersion from a metal oxide powder, the dispersion may be prepared using the dispersing agent of the carbamate compound. Alternatively, the dispersing agent of the carbamate compound may be additionally added later to the dispersion using a dispersing agent other than the carbamate compound. In either case, the effect of promoting the formation of voids is obtained.

As the dispersing agent having a carbamate structure, for example, there may be mentioned "DisperBYK-9077", "DisperBYK-9076", "DisperBYK-163", "DisperBYK-164", "DisperBYK-2163", "DisperBYK-2164", "DisperBYK-2155", all manufactured by BYK Japan KK; "TEGO Dispers 710" manufactured by Evonik Degussa; and the like.

As metal oxide dispersions using the dispersing agent having a carbamate structure, for example, there may be mentioned a zinc oxide particle dispersion "NANOBYK-3821" (primary particle diameter: 20 nm), "NANOBYK-3841" (primary particle diameter: 40 nm), a silicon oxide particle dispersion "NANOBYK-3650" (primary particle diameter: 20 nm), an alumina particle dispersion "NANOBYK-3601" (primary particle diameter: 40 nm), manufactured by BYK Japan KK; and the like.

The carbamate compound is in a ratio of 0.01% to 50%, preferably 0.05% to 30%, more preferably 0.1% to 20% relative to the sum of solid matter weights of the metal oxide and the polysilane in the composition. In this range, a sufficient amount thereof is present for promoting the formation of voids and membrane properties required for the scattering membrane are not remarkably decreased.

### (5) Preparation of Coating Composition

In the composition, the mixing ratio of the metal oxide and the polysilane compound is from 99:1 to 1:99, preferably from 95:5 to 30:70, more preferably 90:10 to 40:60. As mentioned above, voids are formed in the cured product obtained by curing the composition of the invention. It is surmised that the mixture of the metal oxide particles and the polysilane compound is aggregated and combined along with phase separation thereof from the solvent while including gas bubbles to form the voids in the process of drying and removing the solvent. Therefore, in the above mixing ratio, the phase separation, inclusion of gas bubbles, aggregation, combination, and the like smoothly proceed and it becomes possible to easily adjust the diameter of the voids and control of porosity.

In the preparation of the composition, a method can be appropriately selected from a method of dispersing a metal oxide particle powder in a solution containing a polysilane compound dissolved in a solvent to form a dispersion, a method of dissolving a polysilane compound in a metal oxide particle dispersion, and a method of mixing a metal oxide dispersion with a polysilane solution. Since the metal oxide fine particles and the polysilane compound are easily made homogeneous and storage stability of the composition is easily attained, the method of mixing a metal oxide dispersion with a polysilane solution is preferable. Furthermore, it is more preferable that the solvent species of the metal oxide dispersion and the polysilane solution are the same.

As a method for preparing a dispersion of the particles, in general, a solvent, a dispersing agent, the particles, and, if necessary, beads for pulverization are mixed beforehand so that solid matter concentration becomes from 5 to 70% by weight, and the resulting mixture is subjected to a dispersion treatment to prepare a particle dispersion. As a method for the dispersion treatment, for example, there may be used any method, for example, a dispersion treatment by an ultrasonic dispersing machine, dispersing methods by a sand mill, an attritor, Dinomill, a beads mill, a ball mill, a fluidizer, a high-speed mixer, a homogenizer, a paint shaker, and the like.

In order to enhance dispersion stability of the particles, a low-molecular-weight dispersing agent having a carbamate structure or a high-molecular-weight dispersing agent having a carbamate structure usually commercially available as a dispersant is incorporated .

As the high-molecular-weight dispersing agent having a carbamate structure, for example, there may be mentioned urethane-based dispersing agents. These dispersing agents can be used singly or as a mixture of two or more thereof. The ratio of the dispersing agent contained to the particles is preferably from 0.1 to 50% by weight, more preferably from 0.5 to 35% by weight, further preferably from 1 to 30% by weight, and most preferably from 2 to 25% by weight. When the ratio of the dispersing agent contained to the particles is less than 0.1% by weight, there is a concern that the dispersion stability of the particles in the dispersion becomes worse. When the ratio exceeds 50% by weight, there is a concern that the membrane properties of the scattering membrane are decreased.

Moreover, the viscosity of the composition is from about 0.5 mPa.s to 500 mPa.s form the standpoint of applicability. Into the composition, additives such as a surfactant, a fluidity adjusting agent, and an antifoaming agent may be mixed according to need. The thus prepared composition is used as a raw material for forming the porous membrane and the scattering membrane (hereinafter sometimes generically referred to as a "membrane") by the methods described below.

### II. Method for Forming Membrane

A cured product, i.e., a porous membrane, a light scattering membrane, can be formed by applying the coating composition on a suitable substrate such as glass or plastic and removing the solvent.

As an application method, for example, there can be used a known method such as a spin coating method, a dip coating method, a die coating method, a bar coating method, a blade coating method, a roll coating method, a spray coating method, a capillary coating method, a nozzle coating method, an ink-jet method, a screen printing method, a gravure printing method, or a flexographic printing method. Since surface smoothness is easily obtained and the methods are simple and convenient, a spin coating method, a dip coating method, and a die coating method are preferable.

The removal of the solvent can be performed by drying under heating, drying under reduced pressure, or the like. At the time of drying, an upper limit of drying temperature is preferably less than 400°C. When the temperature is less than 400°C, decomposition of the polysilane compound can be suppressed. Moreover, a lower limit value of the drying temperature may be such a temperature that the solvent used can be removed, i.e., boiling point of the solvent or more. In the drying, drying may be conducted in the air or drying may be conducted in an inert gas atmosphere.

### III. Porous Membrane

The cured product formed as mentioned above is a porous membrane in which voids are formed as mentioned later. The membrane not only is useful as the light scattering membrane to be mentioned later but also can be used as an adsorbing body utilizing the fact that it is a porous membrane or as a supporting body of a functional substance such as a catalyst, and the like.

### IV. Light Scattering Membrane

The cured product formed as mentioned above is a porous membrane in which voids are formed as mentioned later. An average diameter of the voids is 100 nm or more and therefore the cured product has a scattering property, so that it can be utilized as a light scattering membrane. For example, it is useful as a light extracting membrane of an organic electroluminescent element.

### <Regarding Refractive Index>

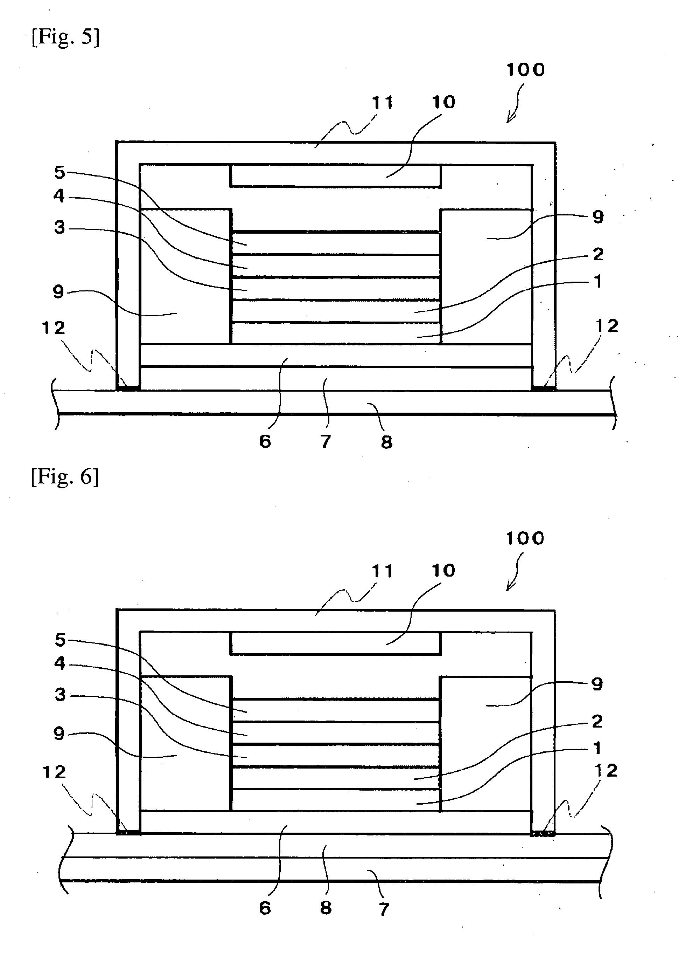

Fig. 5 shows one example of an organic electroluminescent element 100. A light emitted in a light-emitting layer 3 passes through a positive electrode (ITO) 6 having a refractive index higher than that of the light-emitting layer 3 in the whole quantity and reaches an interface between ITO 6 and a scattering membrane 7. On this occasion, in the case where the refractive index of the scattering membrane 7 is equal to or higher than the refractive index of the light-emitting layer 3, the emitted light enters into the scattering membrane 7 in the whole quantity without reflection at the interface and thus the highest light extraction efficiency can be obtained.

Therefore, the refractive index of the scattering membrane is preferably equal to or higher than the refractive index of the light-emitting layer. In general, the refractive index of a material of the light-emitting layer is in the range of 1,7 to 1.8 (example: refractive index of tris(8-hydroxyquinolinato)aluminum; Alq₃ = 1.72@550 nm), the refractive index of the scattering membrane is preferably 1.8 or more, further preferably 1.9 or more. Here, since the refractive index of the polysilane compound constituting the coating composition of the invention is 1.7 or more and the refractive index of a metal oxide, e.g., zinc oxide is 2.0, it becomes possible to incorporate the scattering membrane into the element as a scattering membrane having a preferable refractive index as mentioned above.

Moreover, Fig. 6 shows one example of the organic electroluminescent element 100 in which the scattering membrane 7 is formed at a light-emitting surface side of a substrate 8 such as a glass substrate. The organic electroluminescent element 100 having the scattering membrane 7 at the light-emitting surface side of the substrate 8 can suppress extraction loss of the emitted light, which may be generated at the interface between the glass substrate 8 and the air. On this occasion, in the case where the refractive index of the scattering membrane 7 is equal to or higher than the refractive index of the glass substrate 8 (about 1.5), the emitted light enters into the scattering membrane in the whole quantity without reflection at the interface, and a light extraction efficiency can be obtained.

### <Regarding Void>

The light scattering membrane obtained from the coating composition of the invention has a structure having voids formed on the surface and inside. Regarding the voids, an average diameter thereof is from 10 to 800 nm. In view of a more preferable scattering property, the average diameter of the voids is preferably from 100 to 600 nm.

Moreover, regarding an area ratio of the voids, the ratio is preferably from 2 to 40%. In this range, physical strength can be maintained as a membrane and, for example, in the manufacturing process of the organic electroluminescent element, breakage on the way of the process can be avoided. Also, the membrane is excellent in storage stability.

In the light scattering membrane of the invention, voids, i.e., spaces filled with the air function as a scattering body. Owing to a large difference in refractive index between the air (refractive index = 1.0) and the mixture of the metal oxide particles and the polysilane compound, a high haze, i.e., a high scattering property can be obtained.

A mechanism of forming the voids is not clear but it is surmised that the mixture of the metal oxide particles and the polysilane compound is aggregated and combined along with phase separation thereof from the solvent while including gas bubbles to form the voids in the process of application and drying of the solvent. Accordingly, the average diameter of the voids, the volume fraction of the voids, and the like can be controlled by molecular weight of the polysilane compound, the average diameter of the metal oxide, the mixing ratio of the polysilane compound and the metal oxide, the kind and present ratio of the carbamate compound, and the like.

Moreover, since the scattering body is voids, it is possible to fill any chemical species by replacing the air. For example, any chemical species can be filled into the voids by a method of applying any solution or dispersion over the membrane or a method of impregnation after the scattering membrane is formed.

Furthermore, it is possible to control the scattering property by replacing the voids with chemical species having an arbitrary refractive index or to replace the voids with color-developing chemical species such as a fluorescent body. Thereby, an application of adjusting a color-developing property becomes possible. Moreover, the membrane can be utilized as an adsorbing body utilizing the fact that it is a porous membrane or as a supporting body of a functional substance such as a catalyst.

Moreover, an arbitrary covering layer may be formed on the scattering membrane. For example, in the utilization of the scattering membrane as a light extracting membrane of the organic electroluminescent element, there is a case where smoothness, solvent resistance, acid resistance, alkali resistance, and the like of the outermost surface are required. A covering layer may be formed on the scattering membrane for the purpose of supplementing the required properties. The refractive index of the covering layer is preferably equal to or higher than that of the scattering membrane, for suppressing the reflection of the emitted light at the interface.

The following will describe embodiments of the organic electroluminescent element, the organic EL display device, and the organic EL lighting device containing the scattering membrane of the invention in detail with reference to Fig. 5 but the invention should not be construed as being limited to these contents unless the gist thereof is exceeded. Incidentally, as shown in Fig. 5, the coating composition of the invention is formed in a layer form as the scattering membrane 7 by applying the composition on the substrate 8 and is arranged between the substrate 8 and the positive electrode 6.

### V. Organic Electroluminescent Element

### (Substrate)

The substrate 8 is to be a support of the organic electroluminescent element 100 and usually, a sheet of quartz or glass, a metal sheet or a metal foil, a plastic film or sheet, and the like are used. Of these, preferred are a glass sheet and a sheet or film of a transparent synthetic resin such as polyester, polymethacrylate, polycarbonate, polysulfone, or polyimide. The substrate 8 is preferably composed of a material having a high gas barrier property. Therefore, particularly in the case where a material having a low gas barrier property such as a substrate made of a synthetic resin is used, it is preferable to increase the gas barrier property by providing a dense silicon oxide membrane at least one surface of the substrate 8.

### (Positive Electrode)

The positive electrode 6 has a function of injecting holes into the layer at the light-emitting layer 3 side. The positive electrode 6 is usually composed of a metal such as aluminum, gold, silver, nickel, palladium, or platinum; a metal oxide such as an oxide of indium and/or tin; a metal halide such as copper iodide; carbon black and an electroconductive polymer such as poly(3-methylthiophene), polypyrrole, or polyaniline; and the like. The formation of the positive electrode 6 is usually conducted by a dry method such as a sputtering method or a vacuum deposition method in many cases. Moreover, in the case where the positive electrode is formed using fine particles of a metal such as silver, fine particles of copper iodide or the like, carbon black, electroconductive metal oxide particles, an electroconductive polymer fine powder, or the like, the formation can be also conducted by dispersing them in a suitable binder resin solution and applying the resulting dispersion on the substrate 8. Moreover, in the case where the positive electrode 6 is composed of an electroconductive polymer, the positive electrode can be also formed by directly forming a thin film on the substrate by electrolytic polymerization or applying the electroconductive polymer on the substrate (Appl. Phys. Lett., vol. 60, p. 2711 (1992)).

The positive electrode 6 has usually a single-layer structure but may be appropriately a multi-layer structure. In the case where the positive electrode 6 has a multi-layer structure, a different electroconductive material may be laminated on a first layer positive electrode. The thickness of the positive electrode 6 may be determined depending on required transparency, material, and the like. In the case where particularly high transparency is required, a thickness exhibiting a visual light transmittance of 60% or more is preferable and a thickness exhibiting a transmittance of 80% or more is further preferable. It is preferable that the thickness of the positive electrode 6 is usually 5 nm or more, preferably 10 nm or more and usually 1,000 nm or less, preferably 500 nm or less. On the other hand, in the case where transparency is not required, the thickness of the positive electrode 6 may be arbitrary thickness depending on required strength and the like. In this case, the positive electrode may have the same thickness as that of the substrate.

In the case where membrane formation is conducted on the surface of the positive electrode 6, it is preferable that impurities on the positive electrode are removed by performing a treatment such as ultraviolet rays+ozone, oxygen plasma, or argon plasma and also hole injection ability is improved by adjusting ionization potential thereof.

### (Hole Injection Layer)

A layer having a function of transporting holes from the positive electrode 6 side to the light-emitting layer 3 side is usually called a hole injection and transporting layer or a hole transporting layer. In the case where two or more layers having a function of transporting holes from the positive electrode 6 side to the light-emitting layer 3 side are present, a layer nearer to the positive electrode side is sometimes called a hole injection layer 1. The hole injection layer 1 is preferably used since it strengthens the function of transporting holes from the positive electrode 6 to the light-emitting layer 3 side. In the case of using the hole injection layer 1, the hole injection layer 1 is usually formed on the positive electrode 6.

The thickness of the hole injection layer 1 is usually 1 nm or more, preferably 5 nm or more and is usually 1,000 nm or less, preferably 500 nm or less.

A method for forming the hole injection layer 1 may be a vacuum deposition method or a wet membrane formation method. Since membrane formation properties are excellent, it is preferable to form the layer by the wet membrane formation method.

The hole injection layer 1 preferably contains a hole transporting compound and more preferably contains the hole transporting compound and an electron accepting compound. Furthermore, preferably, a cation radical compound is contained in the hole injection layer 1 and particularly preferably, the layer contains the cation radical compound and the hole transporting compound.

### (Hole Transporting Compound)

A composition for hole injection layer formation usually contains the hole transporting compound to be the hole injection layer 1. Moreover, in the case of the wet membrane formation method, the composition further contains a solvent. It is preferable that the composition for hole injection layer formation has a high hole transportability and can efficiently transport holes injected. Therefore, preferred is one exhibiting a large hole mobility and difficultly generating impurities that become traps, at the time of manufacturing or on use. Moreover, it is preferable that stability is excellent, ionization potential is small, and transparency toward visible light is high. Particularly, in the case where the hole injection layer 1 comes into contact with the light-emitting layer 3, preferred is one that does not quench the light emitted from the light-emitting layer or one that does not form an exciplex with the light-emitting layer and does not decrease light emission efficiency.

As the hole transporting compound, from the standpoint of charge injection barrier from the positive electrode 6 to the hole injection layer 1, a compound having an ionization potential of 4.5 eV to 6.0 eV is preferable. Examples of the hole transporting compound include aromatic amine-based compounds, phthalocyanine-based compounds, porphyrin-based compounds, oligothiophene-based compounds, polythiophene-based compounds, benzylphenyl-based compounds, compounds in which tertiary amines are connected with a fluorene group, hydrazone-based compounds, silazane-based compounds, quinacridone-based compounds, and the like.

Among the above exemplified compounds, in view of non-crystallinity and visible light transmittance, aromatic amine compounds are preferable and aromatic tertiary amine compounds are particularly preferable. Here, the aromatic tertiary amine compound is a compound having an aromatic tertiary amine structure and includes compounds having a group derived from an aromatic tertiary amine.

The kind of the aromatic tertiary amine compound is not particularly limited but, from the standpoint of easily obtaining more homogeneous light emission by a surface smoothening effect, it is preferable to use a macromolecular compound (polymeric compound in which repeating units are ranged) having a weight-average molecular weight of 1,000 to 1,000,000. As a preferable example of the aromatic tertiary amine macromolecular compound, a macromolecular compound having a repeating unit represented by the following formula (I) and the like may be mentioned: 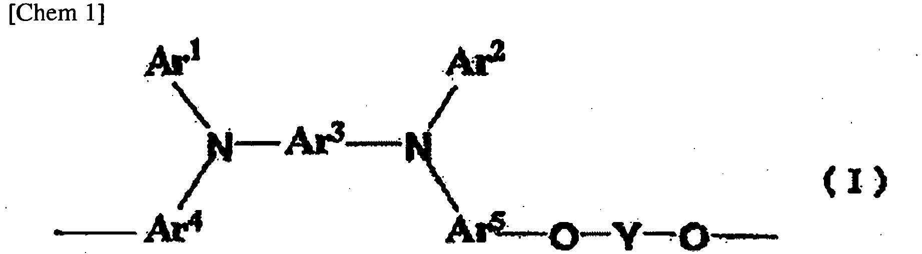 wherein Ar¹ and Ar² are each independently represent an aromatic hydrocarbon group which may have a substituent or an aromatic heterocyclic group which may have a substituent; Ar³ to Ar⁵ are each independently represent an aromatic hydrocarbon group which may have a substituent or an aromatic heterocyclic group which may have a substituent; Y represents a linking group selected from the following group of linking groups; and, of Ar¹ to Ar⁵, two groups combining to the same N atom may be combined to form a ring. 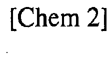 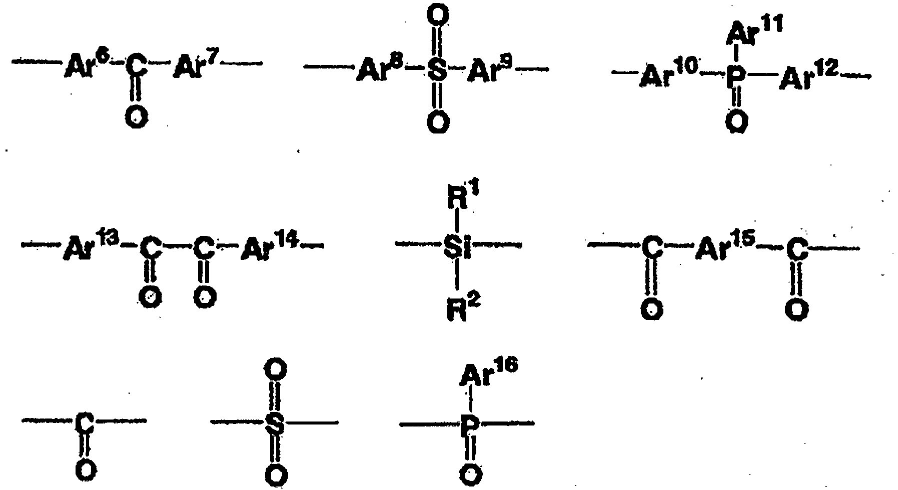 wherein Ar⁶ to Ar¹⁶ are each independently represent an aromatic hydrocarbon group which may have a substituent or an aromatic heterocyclic group which may have a substituent; R¹ and R² are each independently represent a hydrogen atom or an arbitrary substituent.

As the aromatic hydrocarbon group or the aromatic heterocyclic group of Ar¹ to Ar¹⁶, in view of solubility, heat resistance and hole injection and transporting properties of the macromolecular compound, groups derived from a benzene ring, a naphthalene ring, a phenanthrene ring, a thiophene ring, and a pyridine ring are preferable, and groups derived from a benzene ring and a naphthalene ring are further preferable.

Specific examples of the aromatic tertiary amine macromolecular compound having a repeating unit represented by the formula (I) include those described in WO2005/089024 and the like.

### (Electron Accepting Compound)

The hole injection layer 1 preferably contains an electron accepting compound since conductivity of the hole injection layer can be enhanced by oxidation of the hole transporting compound.

As the electron accepting compound, a compound having oxidizability and having an ability of accepting one electron from the aforementioned hole transporting compound is preferable. Specifically, a compound having an electron affinity of 4 eV or more is preferable and a compound having an electron affinity of 5 eV or more is more preferable.

As the electron accepting compound, for example, there may be mentioned one or more compounds selected from the group consisting of triarylboron compounds, metal halides, Lewis acids, organic acids, onium salts, salts of arylamines with metal halides, and salts of arylamines with Lewis acids. Specifically, there may be mentioned onium salts substituted with organic substituents, such as 4-isopropyl-4'-methyldiphenyliodonium tetrakis(pentafluorophenyl)borate and triphenylsulfonium tetrafluoroborate (WO2005/089024); high valency inorganic compounds such as iron(III) chloride (JP-A-11-251067) and ammonium peroxodisulfate; cyano compounds such as tetracyanoethylene; aromatic boron compounds such as tris(pentafluorophenyl)borane (JP-A-2003-31365); fullerene derivatives and iodine; and the like.

### (Cation Radical Compound)

As the cation radical compound, preferred is an ionic compound composed of a cation radical that is a chemical species formed by removing one electron from the hole transporting compound and a counter anion. However, in the case where the cation radical is derived from a hole transporting macromolecular compound, the cation radical has a structure formed by removing one electron from the repeating unit of the macromolecular compound.

As the cation radical, it is preferably a chemical species formed by removing one electron from the compound mentioned above as the hole transporting compound. In view of non-crystallinity, visible light transmittance, heat resistance, and solubility, suitable is a chemical species formed by removing one electron from the compound preferable as the hole transporting compound.

Here, the cation radical compound can be formed by mixing the aforementioned hole transporting compound and the electron accepting compound. Namely, by mixing the aforementioned hole transporting compound and the electron accepting compound, electron transfer is generated from the hole transporting compound to the electron accepting compound, thereby forming a cation ionic compound composed of a cation radical of the hole transporting compound and a counter anion.

The cation radical compound derived from a macromolecular compound such as PEDOT/PSS (Adv. Mater., 2000, vol. 12, p. 481) or emeraldine hydrochloride (J. Phys. Chem., 1990, vol. 94, p. 7716) is also formed by oxidative polymerization (dehydrogenative polymerization).

The oxidative polymerization mentioned here means that a monomer is chemically oxidized using a peroxodisulfate salt or the like or electrochemically oxidized, in an acidic solution. In the case of the oxidative polymerization (dehydrogenative polymerization), the monomer is oxidized to form a macromolecule and also a cation radical resulting from removal of one electron from the repeating unit of the macromolecule, in which an anion derived from the acidic solution is the counter anion.

### <Formation of Hole Injection Layer by Wet Membrane Formation Method>

In the case of forming the hole injection layer by the wet membrane formation method, the layer is usually formed by mixing a material to be the hole injection layer with a soluble solvent (solvent for hole injection layer) to prepare a composition for membrane formation (composition for hole injection layer formation) and applying the composition for hole injection layer formation on a layer (usually positive electrode) corresponding to the lower layer of the hole injection layer to form a membrane, followed by drying.

The concentration of the hole transporting compound in the composition for hole injection layer formation is arbitrary unless the effect of the invention is remarkably impaired but, in view of homogeneity of the membrane thickness, a lower concentration is preferable. On the other hand, in view of difficulty in generation of defects in the hole injection layer, a higher concentration is preferable. Specifically, the concentration is preferably 0.01% by weight or more, further preferably 0.1% by weight or more, particularly preferably 0.5% by weight or more. On the other hand, the concentration is preferably 70% by weight or less, more preferably 60% by weight or less, particularly preferably 50% by weight or less.

Examples of the solvent include ether-based solvents, ester-based solvents, aromatic hydrocarbon-based solvents, amide-based solvents, and the like.

Examples of the ether-based solvents include aliphatic ethers such as ethylene glycol dimethyl ether, ethylene glycol diethyl ether, and propylene glycol-1-monomethyl ether acetate (PGMEA); aromatic ethers such as 1,2-dimethoxybenzene, 1,3-dimethoxybenzene, anisole, phenetole, 2-methoxytoluene, 3-methoxytoluene, 4-methoxytoluene, 2,3-dimethylanisole, and 2,4-dimethylanisole; and the like.

Examples of the ester-based solvents include aromatic esters such as phenyl acetate, phenyl propionate, methyl benzoate, ethyl benzoate, propyl benzoate, and n-butyl benzoate, and the like.

Examples of the aromatic hydrocarbon-based solvents include toluene, xylene, cyclohexylbenzene, 3-isopropylbiphenyl, 1,2,3,4-tetramethylbenzene, 1,4-diisopropylbenzene, cyclohexylbenzene, methylnaphthalene, and the like. Examples of the amide-based solvents include N,N-dimethylformamide, N,N-dimethylacetamide, and the like.

Besides them, dimethyl sulfoxide and the like can be also used.

The formation of the hole injection layer 1 by the wet membrane formation method is usually conducted by preparing the composition for hole injection layer formation and subsequently applying it on a layer (usually, positive electrode 6) corresponding to the lower layer of the hole injection layer 1 to form a membrane, followed by drying.

With regard to the hole injection layer 1, the applied membrane is usually dried by heating, drying under reduced pressure, or the like after the membrane formation.

### <Formation of Hole Injection Layer by Vacuum Deposition Method>

In the case of forming the hole injection layer 1 by the vacuum deposition method, usually, one kind or two or more kinds of constituent materials (aforementioned hole transporting compound, electron accepting compound, etc.) of the hole injection layer 1 are charged into a crucible placed in a vacuum container (in the case of using two or more kinds of materials, usually, individual ones are charged into separate crucibles) and, after inside of the vacuum container is evacuated until about 10⁻⁴ Pa by a vacuum pump, the crucible was heated (in the case of using two or more kinds of materials, usually, individual crucibles are heated) and the material in the crucible is vaporized with controlling the vaporizing amount of the material (in the case of using two or more kinds of materials, usually, the materials are vaporized with individually controlling the vaporizing amount of each material) to form the hole injection layer 1 on the positive electrode on the substrate placed opposite to the crucible(s). Incidentally, in the case of using two or more kinds of materials, a mixture thereof can be also charged into a crucible and heated and vaporized to form the hole injection layer.

The degree of vacuum at the deposition is not limited unless the effect of the invention is remarkably impaired but is usually 0.1*10⁻⁶ Torr (0.13*10⁻⁴ Pa) or more and 9.0*10⁻⁶ Torr (12.0*10⁻⁴ Pa) or less. The deposition rate is not limited unless the effect of the invention is remarkably impaired but is usually 0.1 A/second or more and 5.0 A/second or less. The membrane formation temperature at the deposition is not limited unless the effect of the invention is remarkably impaired but the formation is conducted preferably at 10°C or more and 50°C or less.

Incidentally, the hole injection layer 1 may be crosslinked as in the case of the hole transporting layer to be mentioned later.

### (Hole Transporting Layer)

The hole transporting layer 2 is a layer having a function of transporting holes from the positive electrode 6 side to the light-emitting layer 3 side. The hole transporting layer 2 is not an essential layer in the organic electroluminescent element 100 of the invention but, in view of strengthening the function of transporting holes from the positive electrode 6 to the light-emitting layer 3, it is preferable to use the layer. In the case of using the hole transporting layer 2, usually, the hole transporting layer 2 is formed between the positive electrode 6 and the light-emitting layer 3. Moreover, in the case where the aforementioned hole injection layer 1 is present, the hole transporting layer 2 is formed between the hole injection layer 1 and the light-emitting layer 3.

The thickness of the hole transporting layer 2 is usually 5 nm or more, preferably 10 nm or more and, on the other hand, is usually 300 nm or less, preferably 100 nm or less.

A method of forming the hole transporting layer 2 may be a vacuum deposition method or a wet membrane formation method. In view of an excellent membrane formation property, it is preferable to form the layer by the wet membrane formation method.

The hole transporting layer 2 usually contains a hole transporting compound to be the hole transporting layer. As the hole transporting compound to be contained in the hole transporting layer, particularly, there may be mentioned aromatic diamines containing two or more tertiary amines and having two or more condensed aromatic rings substituted on nitrogen atoms, represented by 4,4'-bis[N-(1-naphthyl)-N-phenylamino]biphenyl (JP-A-5-234681), aromatic amine compounds having a star-burst structure, such as 4,4',4"-tris(1-naphthylphenylamino)triphenylamine (J. Lumin., vol. 72-74, p. 985 (1997)), aromatic amine compounds composed of tetramer of triphenylamine (Chem. Commun.,p. 2175, (1996)), spiro compounds such as 2,2',7,7'-tetrakis(diphenylamino)-9,9'-spirobifluorene (Synth. Metals, vol. 91, p. 209 (1997)), carbazole derivatives such as 4,4'-N,N'-dicarbazolebiphenyl, and the like. Moreover, for example, polyvinylcarbazole, polyvinyltriphenylamine (JP-A-7-53953), and polyarylene ether sulfone containing tetraphenylbenzidine (Polym. Adv. Tech., vol. 7, p. 33 (1996)), and the like are also preferably used.

### <Formation of Hole Transporting Layer by Wet Membrane Formation Method>

In the case of forming the hole transporting layer 2 by the wet membrane formation method, usually, the layer is usually formed in the same manner as in the aforementioned case of forming the hole injection layer 1 by the wet membrane formation method, using a composition for hole transporting layer formation instead of the composition for hole injection layer formation.

In the case of forming the hole transporting layer 2 by the wet membrane formation method, usually, the composition for hole transporting layer formation further contains a solvent. As the solvent for use in the composition for hole transporting layer formation, there can be used a solvent the same as the solvent used in the aforementioned composition for hole injection layer formation.

The concentration of the hole transporting compound in the composition for hole transporting layer formation can be in the same range as that of the concentration of the hole transporting compound in the composition for hole injection layer formation.

The formation of the hole transporting layer by the wet membrane formation method can be conducted as in the case of the aforementioned membrane formation method of the hole injection layer.

### <Formation of Hole Transporting Layer by Vacuum Deposition Method>

Also in the case of forming the hole transporting layer 2 by the vacuum deposition method, usually, the layer can be formed in the same manner as in the aforementioned case of forming the hole injection layer 1 by the vacuum deposition method, using a composition for hole transporting layer formation instead of the composition for hole injection layer formation. The membrane formation can be conducted under conditions for the membrane formation, such as the degree of vacuum, deposition rate and temperature at the deposition, which are the same as in the case of the vacuum deposition of the hole injection layer.

### (Light-Emitting Layer)

The light-emitting layer 3 is a layer having a function of being excited by recombination of holes injected from the positive electrode and electrons injected from the negative electrode and emitting a light. The light-emitting layer 3 is a layer formed between the positive electrode 6 and the negative electrode 5. In the case where the hole injection layer 1 is present on the positive electrode 6, the light-emitting layer 3 is formed between the hole injection layer 1 and the negative electrode 5 and, in the case where the hole transporting layer 2 is present on the positive electrode 6, the light-emitting layer 3 is formed between the hole transporting layer 2 and the negative electrode 5.

The thickness of the light-emitting layer 3 is arbitrary unless the effect of the invention is remarkably impaired but, in view of difficulty in generation of defects on the membrane, thicker one is preferable. On the other hand, thinner one is preferable in view of easiness of driving at low voltage. Therefore, the thickness is preferably 3 nm or more, further preferably 5 nm or more and, on the other hand, is usually preferably 200 nm or less, further preferably 100 nm or less.

The light-emitting layer 3 contains at least a material having a light-emitting property (light-emitting material) and also preferably contains a material having a charge transporting property (charge transporting material).

### (Light-Emitting Material)

The light-emitting material is not limited so long as it emits a light at a desired emission wavelength and the effect of the invention is not impaired, and known light-emitting materials are applicable. The light-emitting material may be a fluorescent light-emitting material or a phosphorescent light-emitting material but a material exhibiting a good light emission efficiency is preferable and, from the standpoint of internal quantum efficiency, the phosphorescent light-emitting material is preferable.

As the fluorescent light-emitting material, for example, the following materials may be mentioned.

As fluorescent light-emitting materials affording blue light emission (blue fluorescent light-emitting materials), for example, there may be mentioned naphthalene, perylene, pyrene, anthracene, coumarin, chrysene, p-bis(2-phenylethenyl)benzene, derivatives thereof, and the like.

As fluorescent light-emitting materials affording green light emission (green fluorescent light-emitting materials), for example, there may be mentioned quinacridone derivatives, coumarin derivatives, aluminum complexes such as Al(C₉H₆NO)₃, and the like.

As fluorescent light-emitting materials affording yellow light emission (yellow fluorescent light-emitting materials), for example, there may be mentioned rubrene, perimidone derivatives, and the like.

As fluorescent light-emitting materials affording red light emission (red fluorescent light-emitting materials), for example, there may be mentioned DCM (4-(dicyanomethylene)-2-methyl-6-(p-dimethylaminostyryl)-4H-pyran)-based compounds, benzopyran derivatives, rhodamine derivatives, benzothioxanthene derivatives, azabenzothioxanthene, and the like.

Moreover, as the phosphorescent light-emitting materials, for example, there may be mentioned organometallic complexes containing a metal selected from the groups 7 to 11 of the long-period periodic table (hereinafter "periodic table" refers to the long-period periodic table unless otherwise stated). As the metals selected from the groups 7 to 11 of the periodic table, there may be preferably mentioned ruthenium, rhodium, palladium, silver, rhenium, osmium, iridium, platinum, gold, and the like.

As ligands for the organometallic complexes, preferred are ligands in which a (hetero)aryl group and pyridine, pyrazole, phenanthroline or the like are connected, such as (hetero)arylpyridine ligands and (hetero)arylpyrazole ligands. Particularly, a phenylpyridine ligand and a phenylpyrazole ligand are preferred. Here, the (hetero)aryl means an aryl group or a heteroaryl group.

As preferable phosphorescent light-emitting materials, specifically, there may be, for example, mentioned phenylpyridine complexes such as tris(2-phenylpyridine)iridium, tris(2-phenylpyridine)ruthenium, tris(2-phenylpyridine)palladium, bis(2-phenylpyridine)platinum, tris(2-phenylpyridine)osmium, and tris(2-phenylpyridine)rhenium; porphyrin complexes such as octaethylplatinum porphyrin, octaphenylplatinum porphyrin, octaethylpalladium porphyrin, and octaphenylpalladium porphyrin; and the like.

As macromolecular light-emitting materials, there may be mentioned polyfluorene-based materials such as poly(9,9-dioctylfluorene-2,7-diyl), poly[(9,9-dioctylfluorene-2,7-diyl)-co-(4,4'-(N-(4-sec-butylphenyl))diphenylamine)], and poly[(9,9-dioctylfluorene-2,7-diyl)-co-(1,4-benzo-2{2,1'-3}-triazole)], polyphenylenevinylene-based materials such as poly[2-methoxy-5-(2-ethylhexyloxy)-1,4-phenylenevinylene].

### (Charge Transporting Material)

The charge transporting material is a material having a positive charge (hole) or negative charge (electron) transporting property and is not particularly limited unless the effect of the invention is impaired, and known light-emitting materials are applicable.

As the charge transporting material, a compound conventionally used in the light-emitting layer of an organic electroluminescent element can be used. Particularly, a compound used as a host material of the light-emitting layer is preferable.

As the charge transporting material, specifically, there may be mentioned the compounds exemplified as the hole transporting compounds of the hole injection layer, such as aromatic amine-based compounds, phthalocyanine-based compounds, porphyrin-based compounds, oligothiophene-based compounds, polythiophene-based compounds, benzylphenyl-based compounds, compounds in which tertiary amines are connected with a fluorene group, hydrazone-based compounds, silazane-based compounds, silanamine-based compounds, phosphamine-based compounds, and quinacridone-based compounds. Besides, there may be mentioned electron transporting compounds such as anthracene-based compounds, pyrene-based compounds, carbazole-based compounds, pyridine-based compounds, phenanthroline-based compounds, oxadiazole-based compounds, and silole-based compounds, and the like.

Moreover, there can be preferably used compounds exemplified as the hole transporting compounds of the hole transporting layer, such as aromatic diamines containing two or more tertiary amines and having two or more condensed aromatic rings substituted on nitrogen atoms represented by 4,4'-bis[N-(1-naphthyl)-N-phenylamino]biphenyl (JP-A-5-234681), aromatic amine compounds having a star-burst structure, such as 4,4',4"-tris(1-naphthylphenylamino)triphenylamine (J. Lumin., vol. 72-74, p. 985 (1997)), aromatic amine compounds composed of tetramer of triphenylamine (Chem. Commun., p. 2175 (1996)), fluorene-based compounds such as 2,2',7,7'-tetrakis(diphenylamino)-9,9'-spirobifluorene (Synth. Metals, vol. 91, p. 209 (1997)), and carbazole-based compounds such as 4,4'-N,N'-dicarbazolebiphenyl, and the like. Moreover, besides them, there may be also mentioned oxadiazole-based compounds such as 2-(4-biphenylyl)-5-(p-tertiary butylphenyl)-1,3,4-oxadiazole (t-Bu-PBD) and 2,5-bis(1-naphthyl)-1,3,4-oxadiazole (BND); silole-based compounds such as 2,5-bis(6'-(2',2"-bipyridyl))-1,1-dimethyl-3,4-diphenylsilole (PyPySPyPy); phenanthroline-based compounds such as bathophenanthroline (BPhen) and 2,9-dimethyl-4,7-diphenyl-1,10-phenanthroline (BCP, bathocuproine); and the like.

<Formation of Light-Emitting Layer by Wet Membrane Formation Method>

A method for forming the light-emitting layer 3 may be the vacuum deposition method or the wet membrane formation method but, because of an excellent membrane formation property, the wet membrane formation method is preferable, and a spin coating method and an ink-jet method are further preferable. In the case of forming the light-emitting layer by the wet membrane formation method, usually, the layer is formed in the same manner as in the aforementioned case of forming the hole injection layer by the wet membrane formation method, using a composition for light-emitting layer formation prepared by mixing a material to be the light-emitting layer with a soluble solvent (solvent for light-emitting layer) instead of the composition for the hole injection layer formation.

As the solvent, for example, there may be mentioned ether-based solvents, ester-based solvents, aromatic hydrocarbon-based solvents, and amide-based solvents which are mentioned for the formation of the hole injection layer and, in addition, alkane-based solvents, halogenated aromatic hydrocarbon-based solvents, aliphatic alcohol-based solvents, alicyclic alcohol-based solvents, aliphatic ketone-based solvents, alicyclic ketone-based solvents, and the like. Specific examples of the solvent may be mentioned below but the solvent is not limited thereto unless the effect of the invention is impaired.

Examples thereof include aliphatic ether-based solvents such as ethylene glycol dimethyl ether, ethylene glycol diethyl ether, and propylene glycol-1-monomethyl ether acetate (PGMEA); aromatic ether-based solvents such as 1,2-dimethoxybenzene, 1,3-dimethoxybenzene, anisole, phenetole, 2-methoxytoluene, 3-methoxytoluene, 4-methoxytoluene, 2,3-dimethylanisole, 2,4-dimethylanisole, and diphenyl ether; aromatic ester-based solvents such as phenyl acetate, phenyl propionate, methyl benzoate, ethyl benzoate, propyl benzoate, and n-butyl benzoate; aromatic hydrocarbon-based solvents such as toluene, xylene, mesitylene, cyclohexylbenzene, tetraline, 3-isopropylbiphenyl, 1,2,3,4-tetramethylbenzene, 1,4-diisopropylbenzene, cyclohexylbenzene, and methylnaphthalene; amide-based solvents such as N,N-dimethylformamide and N,N-dimethylacetamide; alkane-based solvents such as n-decane, cyclohexane, ethylcyclohexane, decaline, and bicyclohexane; halogenated aromatic hydrocarbon-based solvents such as chlorobenzene, dichlorobenzene, and trichlorobenzene; aliphatic alcohol-based solvents such as butanol and hexanol; alicyclic alcohol-based solvents such as cyclohexanol and cyclooctanol; aliphatic ketone-based solvents such as methyl ethyl ketone and dibutyl ketone; alicyclic ketone-based solvents such as cyclohexanone, cyclooctanone, and fenchone; and the like. Of these, the alkane-based solvents and the aromatic hydrocarbon-based solvents are particularly preferable.

### (Hole Blocking Layer)

A hole blocking layer may be provided between the light-emitting layer 3 and an electron injection layer 4 to be mentioned later (not shown in Figures). The hole blocking layer is a layer to be laminated on the light-emitting layer 3 so as to come into contact with the interface at the negative electrode 5 side of the light-emitting layer 3.

The hole blocking layer has a role of blocking arrival of the holes migrating from the positive electrode 6 at the negative electrode 5 and a role of efficiently transporting the electrons injected from the negative electrode 5 toward the direction of the light-emitting layer 3. As physical properties required for the material constituting the hole blocking layer, there may be mentioned a high electron mobility and a low hole mobility, a large energy gap (difference between HOMO and LUMO), and a high excited triplet level (T1).

As materials of the hole blocking layer satisfying such requirements, for example, there may be mentioned mixed ligand complexes such as bis(2-methyl-8-quinolinolato)(phenolato)aluminum and bis(2-methyl-8-quinolinolato)(triphenylsilanolato)aluminum, metal complexes such as bis(2-methyl-8-quinolato)aluminum-µ-oxo-bis-(2-methyl-8-quinolilato)aluminum binuclear metal complex, styryl compounds such as distyrylbiphenyl derivatives (JP-A-11-242996), triazole derivatives such as 3-(4-biphenylyl)-4-phenyl-5(4-tert-butylphenyl)-1,2,4-triazole (JP-A-7-41759), phenanthroline derivatives such as bathocuproine (JP-A-10-79297), and the like. Furthermore, compounds having at least one pyridine ring in which 2-, 4-, and 6-positions are substituted as described in WO2005/022962 are also preferable as materials of the hole blocking layer.

A method for forming the hole blocking layer is not limited. Therefore, it can be formed by the wet membrane formation method, the deposition method, or the other method.

The thickness of the hole blocking layer is arbitrary unless the effect of the invention is remarkably impaired but is usually 0.3 nm or more, preferably 0.5 nm or more and is usually 100 nm or less, preferably 50 nm or less.

### (Electron Transporting Layer)

The electron transporting layer is provided between the light-emitting layer 3 and the electron injection layer 4 for the purpose of further enhancing the current efficiency of the element (not shown in the figures).

The electron transporting layer is formed from a compound capable of efficiently transporting electrons injected from the negative electrode toward the direction of the light-emitting layer 3 between the electrodes to which an electric field is imparted. As an electron transporting compound for use in the electron transporting layer, it is necessary to be a compound having a high electron injection efficiency from the negative electrode or the electron injection layer and a high electron mobility and capable of efficiently transporting electrons injected.

The electron transporting compound for use in the electron transporting layer is usually preferably a compound having a high electron injection efficiency from the negative electrode or the electron injection layer and capable of efficiently transporting electrons injected. As the electron transporting compound, specifically, there may be mentioned metal complexes such as an aluminum complex of 8-hydroxyquinoline (JP-A-59-194393), a metal complex of 10-hydroxybenzo[h]quinoline, oxadiazole derivatives, distyrylbiphenyl derivatives, silole derivatives, 3-hydroxyflavone metal complexes, 5-hydroxyflavone metal complexes, benzoxazole metal complexes, benzothiazole metal complexes, trisbenzimidazolylbenzene (US Patent No. 5645948), quinoxaline compounds (JP-A-6-207169), phenanthroline derivatives (JP-A-5-331459), 2-t-butyl-9,10-N,N'-dicyanoanthraquinonediimine, n-type hydrogenated amorphous silicon carbide, n-type zinc sulfide, n-type zinc selenide, and the like.

The thickness of the electron transporting layer is usually 1 nm or more, preferably 5 nm or more and, on the other hand, is usually 300 nm or less, preferably 100 nm or less.

The electron transporting layer is formed in the same manner as mentioned above by lamination on the hole blocking layer by the wet membrane formation method or the vacuum deposition method. Usually, the vacuum deposition method is used.

### (Electron Injection Layer)

The electron injection layer 4 plays a role of efficiently injecting electrons injected from the negative electrode 5 into the electron transporting layer or the light-emitting layer 3.

In order to efficiently conduct the electron injection, a metal having a low work function is preferable as a material for forming the electron injection layer 4. As examples, alkali metals such as sodium and cesium, alkaline earth metals such as barium and calcium, and the like are used. The thickness thereof is usually preferably 0.1 nm or more and 5 nm or less.

Furthermore, it is also preferable to dope an alkali metal such as sodium, potassium, cesium, lithium, or rubidium on an organic electron transporting material represented by a nitrogen-containing heterocyclic compound such as bathophenanthroline or a metal complex such as an aluminum complex of 8-hydroxyquinoline (described in JP-A-10-270171, JP-A-2002-100478, JP-A-2002-100482, and the like) since electron injection and transporting properties are improved and an excellent membrane quality can be also achieved.

The thickness of the electron injection layer 4 is in the range of usually 5 nm or more, preferably 10 nm or more and is usually 200 nm or less, preferably 100 nm or less.

The electron injection layer 4 is formed on the light-emitting layer or the hole blocking layer formed thereon by lamination by the wet membrane formation method or the vacuum deposition method.

The details of the case of the wet membrane formation method are the same as in the case of the aforementioned light-emitting layer.

### (Negative Electrode)

The negative electrode 5 plays a role of injecting electrons into a layer (electron injection layer, light-emitting layer, or the like) at the light-emitting layer 3 side. As a material for the negative electrode 5, it is possible to use the material to be used in the positive electrode 6 but, for effectively conducting the electron injection, it is preferable to use a metal having a low work function. For example, a metal such as tin, magnesium, indium, calcium, aluminum, or silver, an alloy thereof, or the like is used. Specific examples include electrodes of alloys having a low work function, such as a magnesium-silver alloy, a magnesium-indium alloy, and an aluminum-lithium alloy.

In view of stability of the element, it is preferable to laminate a metal layer, which has a high work function and is stable against the air, on the negative electrode 5 to protect the negative electrode composed of a metal having a low work function. As the metal for use in lamination, for example, there may be mentioned metals such as aluminum, silver, copper, nickel, chromium, gold, and platinum. The thickness of the negative electrode is usually the same as that of the positive electrode.

### (Other Layers)

The organic electroluminescent element 100 of the invention may further have other layers unless the effect of the invention is remarkably impaired. Namely, the element may have aforementioned other arbitrary layers between the positive electrode 6 and the negative electrode 5.

### <Other Element Constitution>

Incidentally, it is also possible to have a structure reverse to that in the aforementioned explanation, i.e., to laminate the negative electrode 5, the electron injection layer 4, the light-emitting layer 3, the hole injection layer 1, and the positive electrode 6 on the substrate 8 in this order.

### <Miscellaneous>

In the case where the organic electroluminescent element 100 of the invention is applied to an organic electroluminescent device, the element may be used as a single organic electroluminescent element, may be used in such a constitution that a plurality of the organic electroluminescent elements are arranged in an array form, or may be used in such a constitution that the positive electrode and the negative electrode are arranged in an X-Y matrix form.

### VI. Organic EL Display Device

The organic EL display device of the invention uses the aforementioned organic electroluminescent element of the invention. The type and structure of the organic EL display device of the invention are not particularly limited and the device can be assembled according to an ordinary method using the organic electroluminescent element of the invention.

For example, the organic EL display device of the invention can be formed by the method described in "Yuki EL Disupurei (Organic EL Display)" (Ohmsha Ltd., published on August 20, 2004, written by Shizuo Tokito, Chihaya Adachi, and Hideyuki Murata).

### VII. Organic EL Lighting

The organic EL lighting of the invention uses the aforementioned organic electroluminescent element of the invention. The type and structure of the organic EL lighting of the invention are not particularly limited and the lighting can be assembled according to an ordinary method using the organic electroluminescent element of the invention.

### Examples

The following will further specifically describe the invention with reference to Manufacture Examples, Examples and Comparative Examples. However, the invention should not be construed as being limited to the following Examples unless the gist thereof is exceeded.

### 1. Measurement of Haze, Total Light Transmittance

The Haze value and the total light transmittance of each of a scattering layer as a scattering membrane and a light extraction membrane were measured using D65 light source as a light source using a Haze computer HZ-2 Model manufactured by Suga Test Instruments Co., Ltd. The adjustment of 0 and 100 values of the Haze computer was conducted in a state that no sample was placed (i.e., a state that only the air was present). Therefore, the Haze value and the total light transmittance of each of the scattering layer and the light extraction membrane to be mentioned later were values including Haze characteristics and total light transmittance characteristics of the glass substrate (glass substrate "OA-10G" (0.7 mm thick) manufactured by Nippon Electric Glass Co., Ltd.).

Incidentally, in the case where the glass substrate alone was measured, Haze is 0.00 and the total light transmittance is 91.8%.

### 2. Measurement of Thickness, Surface Roughness Ra

The thickness of each of a scattering layer and a light extraction membrane was measured using a level difference/surface roughness/fine shape measuring apparatus ("P-15 Model") manufactured by KLA-Tencor Japan Corporation. As the surface roughness, arithmetic average roughness Ra in a range of 2,000 µm was measured.

### 3. Surface Observation on Scanning Electron microscope (SEM) and EDX analysis

After a sample piece was subjected to Au-Pd deposition, a SEM image was measured at an acceleration voltage of 15 kV using a scanning electron microscope S-4100 Model manufactured by Hitachi Ltd.

EDX (energy dispersive X-ray spectroscopy) analysis was measured on Quantax 200 (detector: Xflash 4010) manufactured by Bruker.

### 4. Measurement of Average Particle Diameter of Metal Oxide Dispersion

The average particle diameter of a metal oxide dispersion was measured using a dense particle diameter analyzer (FPAR-1000 Model, dynamic light scattering method) manufactured by Otsuka Electronics Co., Ltd. As the primary particle diameter, a published value of a manufacturer thereof was utilized.

### 5. Molecular Weight of Polysilane

A value in the test result table of a manufacturer thereof attached to a polysilane compound used was utilized.

The molecular weights (Mw and Mn) of a polysilane "OGSOL SI-20-10 (improved)" manufactured by Osaka Gas Chemicals Co., Ltd. were 1,200 and 900. The molecular weights (Mw and Mn) of idem "OGSOL SI-20-10" were 1,500 and 800. The molecular weights (Mw and Mn) of idem "OGSOL SI-10-10" were 13,800 and 1,900. The molecular weights (Mw and Mn) of idem "OGSOL SI-10-20" were 1,600 and 1,100.

Moreover, idem "OGSOL SI-30-10" is decaphenylcyclopentasilane (CAS No. 1770-54-3), so that the molecular weight is 911.

### 6. Measurement of Substituent Molar Ratio (ratio of methyl group, phenyl group) of Polysilane Compound

A polysilane was dissolved in deuterated chloroform and quantitatively determined by measuring proton NMR on NMR (400 MHz) of Bruker.

The substituent molar ratio (methyl group:phenyl group) of a polysilane "OGSOL SI-20-10 (improved)" manufactured by Osaka Gas Chemicals Co., Ltd. was about 1:3. The substituent molar ratio (methyl group:phenyl group) of idem "OGSOL SI-20-10" was about 1:10. The substituent molar ratio (methyl group:phenyl group) of idem "OGSOL SI-10-10" was about 1:1. The substituent molar ratio (methyl group:phenyl group) of idem "OGSOL SI-10-20" was about 1:2.

### 7. Structural Identification of Dispersing Agent Component in Metal Oxide Dispersion and Commercially Available Dispersing Agent

The solvent of a metal oxide dispersion was removed by evaporation and the residue was re-dissolved in deuterated chloroform/deuterated DMSO solvent. Proton NMR was measured on NMR (400 MHz) of Bruker to identify a primary structure.

It was confirmed that the structure of the dispersing agent component of a zinc oxide nano particle dispersion "NANOBYK-3841" manufactured by BYK Japan KK contains hexamethylene dicarbamate, butoxypolypropylene glycol, and polycaprolactone.

It was confirmed that the structure of the dispersing agent component of a titanium oxide particle dispersion "No. 280" manufactured by Mikuni Color Co., Ltd. contains a product of subjecting an amidation product of a polyester (n=10 or less) of hydroxy-unsaturated fatty acid having 15 to 20 carbon atoms and N,N-dimethylpropanediamine to further quaternary ammonium salt formation.

It was confirmed that the structure of a dispersing agent "DISPERBYK-111" manufactured by BYK Japan KK contains polyethylene glycol, polycaprolactone, and a phosphate ester.

It was confirmed that the structure of a dispersing agent "BYK-9077" manufactured by BYK Japan KK contains hexamethylene dicarbamate, butoxypolypropylene glycol, and polycaprolactone.

Incidentally, it was impossible to confirm the presence of a carbamate compound for ZRPMA15WT%-E5, Mikuni Color No. 280, and NANOBYK-3812.

### (Example 1)

### <Formation of Scattering Layer 1>

Propylene glycol monomethyl ether acetate (hereinafter referred to as "PGMEA") (8.0 g) was added to 2.0 g of a polysilane "OGSOL SI-20-10 (improved)" manufactured by Osaka Gas Chemicals Co., Ltd. and they were dissolved under stirring. The solution was filtrated through a 0.2 µm PTFE filter (auto-vial AV125EORG) to prepare "SI-20-10 (improved) PGMEA solution (20 wt%)".

Then, 2.0 g of a zinc oxide nano particle dispersion "NANOBYK-3841" (primary particle diameter of zinc oxide: 40 nm, average particle diameter determined by dynamic light scattering measurement: 125 nm, solvent species: PEGMEA) manufactured by BYK Japan KK was added to 1.0 g of "SI-20-10 (improved) PGMEA solution (20 wt%)" and the whole was stirred for 1 minute using a pencil mixer to prepare a scattering layer coating liquid.

The scattering layer coating liquid was placed in an amount of 0.3 ml on a glass substrate "OA-10G" (37.5 mm*25 mm*0.7 mm thick) manufactured by Nippon Electric Glass Co., Ltd. and applied thereon by spin coating (spin coater: 1H-360S Model manufactured by Mikasa, number of rotations at spin coating: 500 rpm for 10 seconds, subsequently 1,000 rpm for 30 seconds). The coated substrate was subjected to pre-drying at 120°C for 2 minutes on a hot plate and subsequently to main drying at 350°C for 30 minutes. Thereafter, the substrate was subjected to natural cooling to obtain a scattering layer 1 on the glass substrate.

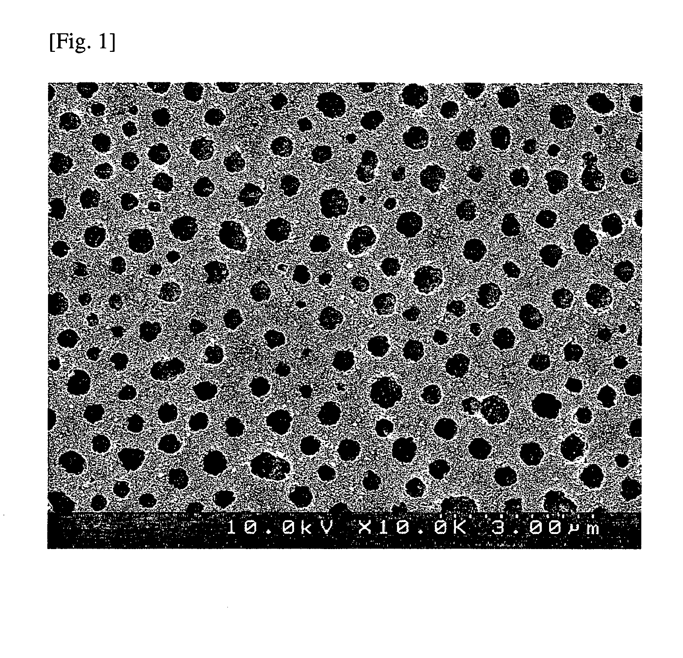

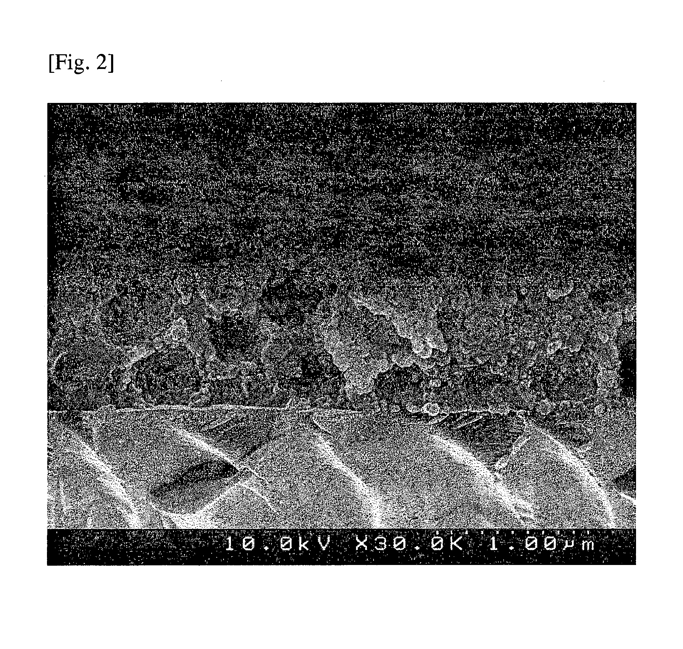

When the scattering layer 1 was observed on a scanning electron microscope (hereinafter referred to as SEM), it was confirmed that voids were formed, from both of a surface image and a cross-sectional image (see Figs. 1 and 2). When average diameter of the voids (arithmetic average value of 10 voids) from the surface image shown in Fig. 1, it was 330 nm. Moreover, when the area ratio of the voids occupying in the total area was determined similarly from the surface image, it was 20.4%.

Furthermore, the thickness of the scattering layer 1 was 0.85 µm, Haze value was 80.8, and the total light transmittance was 71.9%. Additionally, when the refractive index of the coated film was measured by using a prism coupler method, it was 2.357 (633 nm).

### (Examples 2 to 4)

### <Formation of Scattering Layers 2 to 4>

Using the scattering layer coating liquid prepared in Example 1, application by spin coating was performed on the glass substrate under the same conditions as in Example 1, and pre-drying at 120°C for 2 minutes was conducted on a hot plate. Subsequently, main drying was conducted at 220°C (Example 2), at 170°C (Example 3), or at 120°C (Example 4) for 30 minutes and natural cooling was performed to obtain scattering layers 2 to 4 on the glass substrate.

Upon SEM observation, the formation of voids was confirmed on the surface and at the cross-section for all the scattering layers.

### (Examples 5 to 11)

### <Formation of Scattering Layers 5 to 11)

Scattering layers 5 to 8 were obtained by the method described in Example 1 except that the mixing weights of "SI-20-10 (improved) PGMEA solution (20 wt%)" and "NANOBYK-3841" were changed as described in the following Table 1.

Moreover, scattering layer coating liquids were prepared in the mixing ratios described in Table 1 using "SI-10-10 PGMEA solution (20 wt%)", "SI-10-20 PGMEA solution (20 wt%)", and "SI-30-10 tetrahydrofuran (hereinafter referred to as THF) solution (10 wt%)" prepared by dissolving each brand polysilane in each solvent, and scattering layers 9 to 11 were obtained by the method described in Example 1.

Upon SEM observation, the formation of voids was confirmed on the surface and at the cross-section for all the scattering layers.

### (Examples 12 to 15)

### <Formation of Scattering Layers 12 to 15)

Scattering layer coating liquids were prepared in the mixing ratios described in Table 1 using a zinc oxide nano particle dispersion "NANOBYK-3841" (primary particle diameter of zinc oxide: 20 nm, average particle diameter determined by dynamic light scattering: 98 nm, solvent species: PEGMEA) manufactured by BYK Japan KK, an aluminum oxide nano particle dispersion "NANOBYK-3610" (primary particle diameter of aluminum oxide: 20 to 25 nm, average particle diameter determined by dynamic light scattering: 110 nm, solvent species: PEGMEA) manufactured by the same company, and a silicon oxide nano particle dispersion "NANOBYK-3650" (primary particle diameter of silicon oxide: 20 to 25 nm, average particle diameter by dynamic light scattering was not yet measured, solvent species: PEGMEA and methoxypropanol) manufactured by the same company, and scattering layers 12 to 15 were obtained by the method described in Example 1.

Upon SEM observation, the formation of voids was confirmed on the surface and at the cross-section for all the scattering layers.

### (Comparative Example 1)

### <Formation of Scattering Layer 16>

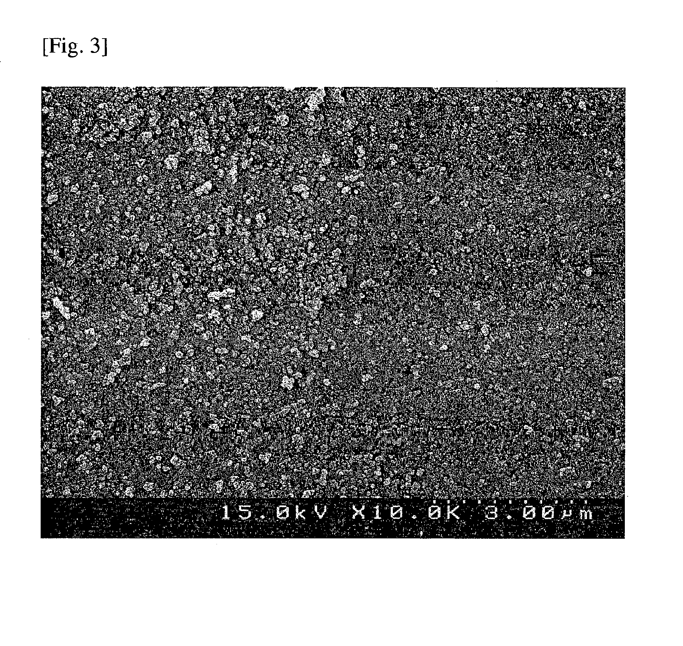

A scattering layer 16 was obtained on the glass substrate by the same method as described in Example 1 except that "NANOBYK-3841" alone was used instead of the scattering layer coating liquid prepared in Example 1. Upon surface observation by SEM, it was confirmed that voids were not formed in the scattering layer 16 (see Fig. 3).

### (Comparative Example 2)

### <Formation of Scattering Layer 17>

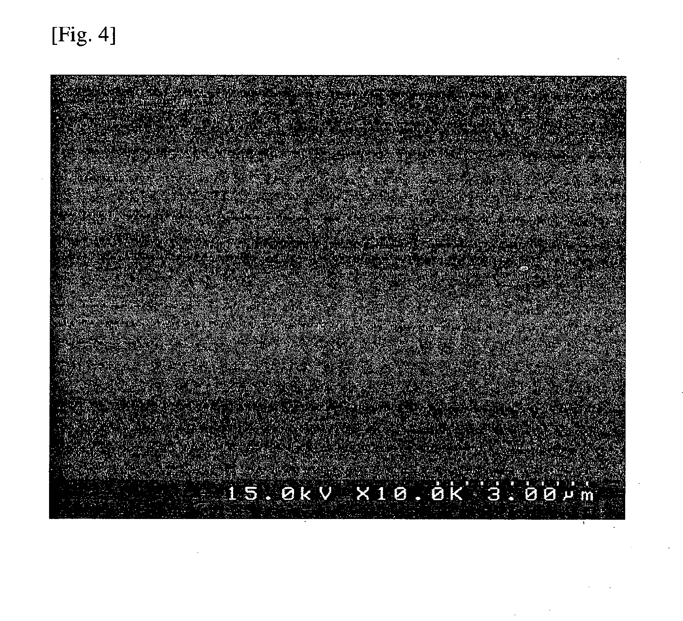

A scattering layer 17 was obtained on the glass substrate by the same method as described in Example 1 except that "SI-20-10 (improved) PGMEA solution (20 wt%)" alone was used instead of the scattering layer coating liquid prepared in Example 1. Upon surface observation by SEM, it was confirmed that voids were not formed in the scattering layer 17 (see Fig. 4).

### (Comparative Examples 3 to 5)

### <Formation of Scattering Layers 18 to 20)

Scattering layer coating liquids were prepared in the mixing ratios described in Table 1 using a zirconium oxide nano particle dispersion "ZRPMA15WT%-E5" (primary particle diameter of zirconium oxide: 20 nm, average particle diameter determined by dynamic light scattering: 58 nm, solvent species: PEGMEA) manufactured by CIK Nano Tec KK, a titanium oxide nano particle dispersion "No. 280" (average particle diameter of titanium oxide determined by dynamic light scattering: 110 nm, solvent species: toluene) manufactured by Mikuni Color Co., Ltd., and a cerium oxide nano particle dispersion "NANOBYK-3812" (primary particle diameter of cerium oxide: 10 nm, average particle diameter by dynamic light scattering was not yet measured, solvent species: aromatic free white spirit) manufactured by BYK Japan KK, and scattering layers 18 to 20 were obtained by the method described in Example 1.

Upon surface observation by SEM, it was confirmed that voids were not formed in the scattering layers 18 to 20.

**[Table 1]**

| | | Composition of scattering layer coating liquid (mixing ratio) | | | |
|---|---|---|---|---|---|
| | | Metal oxide dispersion | | Polysilane solution | |
| | | Brand (chemical species, average particle diameter, concentration of metal oxide) | Amount added | Brand | Amount added |
| Examples 1 to 4(*) | Scattering layer 1 to 4 | NANOBYK-3841 (ZnO, 125nm, 40wt%) | 2.0 g | SI-20-10 (improved) PGMEA solution (20wt%) | 1.0 g |
| Example 5(*) | Scattering layer 5 | the same as above | 2.0 g | the same as above | 0.5 g |
| Example 6(*) | Scattering layer 6 | the same as above | 2.0 g | the same as above | 1.33 g |
| Example 7(*) | Scattering layer 7 | the same as above | 2.0 g | the same as above | 1.77 g |
| Example 8(*) | Scattering layer 8 | the same as above | 2.0 g | the same as above | 2.0 g |
| Example 9(*) | Scattering layer 9 | the same as above | 2.0 g | SI-10-10 PGMEA solution (20wt%) | 1.0 g |
| Example 10(*) | Scattering layer 10 layer 10 | the same as above | 2.0 g | SI-10-20 PGMEA solution (20wt%) | 1.0 g |
| Example 11(*) | Scattering layer 11 | the same as above | 1.0 g | SI-30-10 THF solution (10wt%) | 1.0 g |
| Example 12(*) | Scattering layer 12 | NANOBYK-3821 (ZnO, 98nm, 40wt%) | 2.0 g | SI-20-10 (improved) PGMEA solution (20wt%) | 1.0 g |
| Example 13(*) | Scattering layer 13 | NANOBYK-3610 (Al203, 110nm, 30wt%) | 2.0. g | SI-20-10 (improved) PGMEA solution (20wt%) | 1.0 g |
| Example 14(*) | Scattering layer 14 | the same as above | 2.0 g | SI-10-10 PGMEA solution (20wt%) | 1.0 g |
| Example 15(*) | Scattering layer 15 | NANOBYK-3650 (SiO2, not measured, 25wt%) | 2.4 g | SI-20-10 (improved) PGMEA solution (20wt%) | 1.0 g |
| Comparative Example 1(*) | Scattering layer 16 | NANOBYK-3841 (ZnO, 125nm, 40wt%) | 2.0 g | none | - |
| Comparative Example 2(*) | Scattering layer 17 | none | - | SI-20-10 (improved) PGMEA solution (20wt%) | 1.0 g |
| Comparative Example 3(*) | Scattering layer 18 | ZRPMA15WT%-E5 (ZrO2, 58nm, 15wt%) | 5.33 g | SI-20-10 (improved) PGMEA solution (20wt%) | 1.0 g |
| Comparative Example 4(*) | Scattering layer 19 | Mikuni Color No. 280 (TiO2, 110nm, 20wt%) | 3.6 g | the same as above | 1.0 g |
| Comparative Example 5(*) | Scattering layer 20 | NANOBYK-3812 (CeO2, not measured, 30wt%) | 1.7 g | the same as above | 1.0 g |

| | | | | | |
|---|---|---|---|---|---|
| (*) Not according to the invention | | | | | |

For the scattering layers 1 to 20, the presence of the formation of voids, average diameter of voids, area ratio of voids, thickness, Haze value, total light transmittance, and surface roughness (Ra) were measured. The results are shown in Table 2.

**[Table 2]**

| | Scattering layer No. | Composition of scattering membrane coating liquid | | | | Preparation conditions of scattering membrane | Physical properties of scattering membrane | | | | | | |
|---|---|---|---|---|---|---|---|---|---|---|---|---|---|
| | | | | | | | SEM observation | | | | | | |
| | | Composition ratio of solid matter in coating liquid (wt%) | | Solid matter concentration of coating liquid (wt%) | Carbamate compound in Scattering layer coating liquid | Drying temperature of coated film (time) | Formation of voids | Average diameter of voids (nm) | Area ratio of voids (%) | Thick-ness (um) | Haze | Total light trans-mittance (%) | Surface roughness Ra (nm) |
| | | Metal oxide | Polysilane | | | | | | | | | | |
| Example 1 (*) | Scattering layer 1 | 80 | 20 | 33 | present | 350°C (30min) | yes | 330 | 20.4%_{'} | 0.85 | 80.8 | 71.9 | 4.8 |
| Example 2(*) | Scattering layer 2 | 80 | 20 | 33 | present | 220°C(30min) | yes | 450 | 11.8% | - | - | - | - |
| Example 3(*) | Scattering layer 3 | 80 | 20 | 33 | present | 170°C (30min) | yes | 410 | 11.8% | 0.63 | 34.3 | 87.3 | 7.3 |
| Example 4(*) | Scattering layer 4 | 80 | 20 | 33 | present | 120°C (30min) | yes | 440 | 11.5% | 0.63 | 16.4 | 86.5 | - |
| Example 5(*) | Scattering layer 5 | 89 | 11 | 36 | present | 350°C (30min) | yes | 430 | 12.4% | 1.01 | 86.6 | 75.3 | 2.3 |
| Example 6(*) | Scattering layer 6 | 75 | 25 | 32 | present | 350°C (30min) | yes | 380 | 22.3% | 0.57 | 75.1 | 82.4 | - |
| Example 7(*) | Scattering layer 7 | 70 | 30 | 31 | present | 350°C (30min) | yes | 450 | 28.2% | 0.98 | 85.9 | 90.2 | - |
| Example 8(*) | Scattering layer 8 | 66 | 34 | 30 | present | 350°C (30min) | yes | 350 | 17.4% | 0.99 | 85.6 | 95.4 | - |
| Example 9(*) | Scattering layer 9 | 80 | 20 | 33 | present | 350°C (30min) | yes | 620 | 20.9% | - | - | - | - |
| Example 10(*) | Scattering layer 10 | 80 | 20 | 33 | present | 350°C (30min) | yes | 120 | 3.0% | - | - | - | - |
| Example 11(*) | Scattering layer 11 | 80 | 20 | 25 | present | 350°C (30min) | yes | 2300 | 19.8% | - | - | - | - |
| | | | | | | | | 740 | | | | | |
| Example 12(*) | Scattering layer 12 | 80 | 20 | 33 | present | 350°C (30min) | yes | 590 | 19.3% | 0.85 | 84.3 | 79.3 | 14.0 |
| Example 13(*) | Scattering layer 13 | 75 | 25 | 27 | present | 350°C (30min) | yes | 280 | 7.2% | - | - | - | - |
| Example 14(*) | Scattering layer 14 | 75 | 25 | 27 | present | 350°C (30min) | yes | 420 | 8.2% | - | - | - | - |
| Example 15(*) | Scattering layer 15 | 75 | 25 | 24 | present | 350°C (30min) | yes | 510 | 10.7% | - | - | - | - |
| Comparative Example 1(*) | Scattering layer 16 | 100 | 0 | 40 | present | 350°C(30min) | no | - | - | 0.72 | 1.7 | 89.3 | 2.3 |
| Comparative Example 2(*) | Scattering layer 17 | 0 | 100 | 20 | absent | 350°C (30min) | no | - | - | 0.99 | 0.1 | 90.8 | 13.9 |
| Comparative Example 3(*) | Scattering layer 18 | 80 | 20 | 16 | absent | 350°C(30min) | no | - | - | 0.44 | 30.3 | 85.6 | - |
| Comparative Example 4(*) | Scattering layer 19 | 75 | 25 | 24 | absent | 350°C (30min) | no | - | - | - | - | - | - |
| Comparative Example 5(*) | Scattering layer 20 | 75 | 25 | 26 | absent | 350°C(30min) | no | - | - | - | - | - | - |

| | | | | | | | | | | | | | |
|---|---|---|---|---|---|---|---|---|---|---|---|---|---|
| (*) Not according to the invention | | | | | | | | | | | | | |

### (Example 16)

### <Preparation of Dispersion A>

In a 30 ml glass vial fitted with a cap were placed 1.20 g of a titanium oxide powder "TTO-51(A)" (primary particle diameter: 10 to 30 nm) manufactured by Ishihara Sangyo Kaisha, Ltd., 4.74 g of PEGMEA, and 0.24 g of a dispersing agent "BYK-9077" manufactured by BYK Japan KK, and 20 g of 0.5 mmφ zirconia beads. After tightly closed, the vial was shaken for 4 hours on a paint shaker (PC type) manufactured by Asada Tekko KK to perform a dispersion treatment. The dispersion was filtrated through a 200-mesh steel net to remove the zirconia beads, thereby obtaining a dispersion A. The average particle diameter of the dispersion was 200 nm.

### <Formation of Scattering Layer 21>

Then, 3.6 g of the dispersion A was added to 1.0 g of "SI-20-10 (improved) PGMEA solution (20 wt%)" and the whole was stirred for 1 minute using a pencil mixer to prepare a scattering layer coating liquid. Using the scattering layer coating liquid, a scattering layer 22 was formed by the method described in Example 1.

### (Examples 17 to 20, Comparative Example 6)

### <Preparation of Dispersions B to F>

Dispersions B to F were prepared by the method described in Example 16 except that the metal oxide powder and the dispersing agent were changed to those in Table 3.

**[Table 3]**

| | Composition ratio at dispersion preparation | | | | Average Particle diameter of particle dispersion (nm) |
|---|---|---|---|---|---|
| | Metal oxide powder | Amount added | Dispersing agent | Amount added | |
| Dispersion A | titanium oxide powder "TTO-51(A)" (primary particle diameter: 10 to 30 nm) manufactured by Ishihara Sangyo Kaisha, Ltd. | 1.2 g | "BYK-9077" manufactured by BYK Japan KK | 0.24 g | 200 |
| Dispersion B | "cerium oxide" powder manufactured by Musashino Denshi Kogyo | 1.2 g | "BYK-9077" manufactured by BYK Japan KK | 0.12 g | 171 |
| Dispersion C | "cerium oxide" powder manufactured by Musashino Denshi Kogyo | 1.2 g | "BYK-9077" manufactured by BYK Japan KK | 0.24 g | 181 |
| Dispersion D | "tantalum oxide" powder manufactured by Kojundo Chemical | 1.2 g | "BYK-9077" manufactured by BYK Japan KK | 0.12 g | 270 |
| Dispersion E | "tantalum oxide" powder manufactured by Kojundo Chemical | 1.2 g | "BYK-9077" manufactured by BYK Japan KK | 0.24 g | 238 |
| Dispersion F | "titanium oxide powder "TTO-55(C)" (primary particle diameter: 30 to 50 nm) manufactured by Ishihara Sangyo Kaisha, Ltd. | 1.2 g | "DISPERBYK-111" manufactured by BYK Japan KK | 0.12 g | 166 |

### <Formation of Scattering Layers 22 to 26>

Scattering layer coating liquids were prepared in mixing ratios described in Table 4, and scattering layers 22 to 26 were formed by the method described in Example 1.

For the scattering layers 21 to 26, the presence of the formation of voids, average diameter of voids, and area ratio of voids were measured. The results are shown in Table 4. The formation of voids was observed in all the scattering layers formed from the scattering layer coating liquids containing the "BYK-9077" dispersing agent that is a carbamate compound but the formation of voids was not observed in the scattering layer formed from the scattering layer coating liquid containing no carbamate compound.

**[Table 4]**

| | | Composition of scattering layer coating liquid (mixing ratio) | | | | Carbamate compound in Scattering layer coating liquid | Physical properties of scattering membrane | | |
|---|---|---|---|---|---|---|---|---|---|
| | | Metal oxide dispersion | | Polysilane solution | | | SEM observation | | |
| | | Brand (chemical species, average particle diameter, concentration of metal oxide) | Amount added | Brand | Amount added | | Formation of voids | Average diameter of voids (nm) | Area ratio of voids (%) |
| Example 16 | Scattering layer 21 | Dispersion A (TiO2, 200nm, 20wt%) | 3.6 g | SI-20-10 (improved) PGMEA solution (20wt%) | 1.0 g | present | yes | 180 | 4.7% |
| Example 17 | Scattering layer 22 | Dispersion B (CeO2, 171nm, 20wt%) | 3.6 g | the same as above | 1.0 g | present | yes | 320 | 18.1% |
| Example 18 | Scattering layer 23 | Dispersion C (CeO2, 181nm, 20wt%) | 3.6 g | the same as above | 1.0 g | present | yes | 460 | 15.5% |
| Example 19 | Scattering layer 24 | Dispersion D (Ta2O5, 270nm, 20wt%) | 3.6 g | the same as above | 1.0 g | present | yes | 520 | 30.0% |
| Example 20 | Scattering layer 25 | Dispersion E (Ta2O5, 238nm, 20wt%) | 3.6 g | the same as above | 1.0 g | present | yes | 590 | 30.8% |
| Comparative Example 6 (*) | Scattering layer 26 | Dispersion F (TiO2, 166nm, 20wt%) | 3.6 g | the same as above | 1.0 g | absent | no | - | - |

| | | | | | | | | | |
|---|---|---|---|---|---|---|---|---|---|
| (*) Not according to the invention | | | | | | | | | |

### (Examples 21 to 24, Comparative Example 7)

### <Formation of Scattering Layer 27 to 31>

New scattering layer coating liquids were prepared by additionally adding "BYK-9077" as a carbamate compound in mixing ratios described in Table 5 to the scattering layer coating liquids of Comparative Examples 2 to 6 for which no void formation was observed and, using the new liquids, scattering layers 27 to 31 were formed by the method described in Example 1.

For the scattering layers 27 to 31, the presence of the formation of voids, average diameter of voids, and area ratio of voids were measured. The results are shown in Table 5.

**[Table 5]**

| | | Composition of scattering layer coating liquid (mixing ratio) | | | | Carbamate compound in Scattering layer coating liquid | Physical properties of scattering membrane | | |
|---|---|---|---|---|---|---|---|---|---|
| | | | | | | | SEM observation | | |
| | | Original scattering layer coating liquid | Amount added | Carbamate compound added | Amount added | | Formation of voids | Average diameter of voids (nm) | Area ratio of voids (%) |
| Example 21 | Scattering layer 27 | Scattering layer coating liquid of Comparative Example 3 | 6.33 g | DisperBYK-9077 | 0.008 g | present | yes | 300 | 3.8% |
| Example 22 | Scattering layer 28 | Scattering layer coating liquid of Comparative Example 4 | 4.6 g | DisperBYK-9077 | 0.008 g | present | yes | 210 | 9.1% |
| Example 23 | Scattering layer 29 | Scattering layer coating liquid of Comparative Example 5 | 2.7 g | DisperBYK-9077 | 0.008 g | present | yes | 450 | 28.3% |
| Example 24 | Scattering layer 30 | Scattering layer coating liquid of Comparative Example 6 | 4.6 g | DisperBYK-9077 | 0.008 g | present | yes | 170 | 9.4% |
| Comparative Example 7 (*) | Scattering layer 31 | Scattering layer coating liquid of Comparative Example 2 | 4.6 g | DisperBYK-9077 | 0.008 g | absent | no | - | - |

| | | | | | | | | | |
|---|---|---|---|---|---|---|---|---|---|
| (*) Not according to the invention | | | | | | | | | |

From the results of Table 5, it was confirmed that the effect of forming voids in the scattering layer is obtained also by additionally adding the "BYK-9077" dispersing agent that is a carbamate compound later (Examples 21 to 24). On the other hand, On the other hand, even when the "BYK-9077" dispersing agent that is a carbamate compound was added to the scattering layer coating liquid of Comparative Example 2 in which the SI-20-10 (improved) PGMEA solution (20 wt%) alone was used, voids were not formed in the scattering layer (Comparative Example 7).

### (Example 25)

### <Preparation of Organic Electroluminescent Element>

An organic electroluminescent element was prepared by the following method. Incidentally, the structure of the organic electroluminescent element is as shown in Figure 5.

### 1. Formation of Light Extraction Membrane A

On the scattering layer 1 on the glass substrate 8 prepared in Example 1 was placed 0.5 ml of a rutile type titanium oxide nano particle dispersion "15%RTiO₂0.02um-high-dispersion" (average particle diameter of titanium oxide: 20 nm, solid matter concentration: 15%, solvent: n-butanol/diacetone alcohol=80/20 (weight ratio)), followed by application by spin coating (spin coater: 1H-360S Model manufactured by Mikasa, number of rotations at spin coating: 500 rpm for 10 seconds, subsequently 1,000 rpm for 30 seconds). The coated substrate was subjected to pre-drying at 120°C for 2 minutes on a hot plate and subsequently to main drying at 350°C for 30 minutes. Thereafter, the substrate was subjected to natural cooling to obtain a "light extraction membrane A" as a scattering membrane 7 in which a titanium oxide nano particle layer was laminated on the scattering layer 1.

### 2. Formation of Positive Electrode

A transparent electroconductive membrane composed of indium tin oxide (ITO) having a thickness of 70 nm was formed as a positive electrode 6 on the light extraction membrane A.

### 3. Washing of Substrate

The glass substrate on which the above positive electrode had been formed was treated for 10 minutes in an ultrasonic washing machine in a state that the substrate was dipped in a 3% aqueous surfactant solution of SEMICLEAN L.G.L manufactured by Yokohama Oils & Fats Industry Co., Ltd. Then, the substrate was rinsed with pure water and air-dried.

Thereafter, the air-dried substrate was subjected to UV ozone washing for 1 minute in a UV ozone washing machine.

### 4. Formation of Open Bank

A negative photosensitive resin solution was prepared by mixing 10.0 g of SPCM-144 manufactured by Showa Denko K.K., 6.1 g of NK oligo U-6LPA manufactured by Shin-Nakamura Chemical Co., Ltd., 0.8 g of IRGACURE 907 manufactured by Ciba Japan, and 22.1 g of propylene glycol monomethyl ether acetate.

The negative photosensitive resin solution was applied on the positive electrode 6 by spin coating and exposure by UV irradiation was conducted through a light-shielding mask having an opening area of 6 mm*6 mm. After development with an aqueous tetramethylammonium hydroxide solution was performed, baking of a bank was conducted in a hot-air oven at 260°C for 1 hour to form an open bank 9 having a bank wall height of 1.4 µm and an opening area of 6 mm*6 mm.

### 5. Formation of Hole Injection Layer

A composition for hole injection layer formation was prepared by mixing a macromolecular compound having a repeating unit shown below and 4-isopropyl-4-methyldiphenyliodonium tetrakis(pentafluorophenyl)borate in a weight ratio of 100:20 and adding ethyl benzoate so that the concentration of the mixture became 2.4% by weight, followed by heating and dissolution.

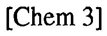

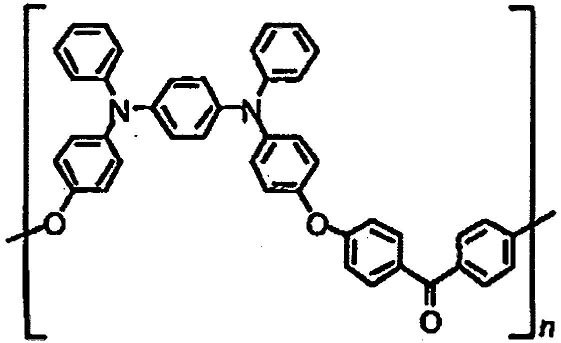

In the above formula, n is an integer of 3 to 100,000.

The composition for hole injection layer formation was applied on the positive electrode 6 surrounded by the open bank 9 by spin coating in an air atmosphere (number of rotations at spin coating: 500 rpm for 10 seconds, subsequently 1,500 rpm for 30 seconds). The coated film was heated in a clean oven at 230°C to form a hole injection layer 1 having a thickness of 35 nm.

### 6. Formation of Hole Transporting Layer

A compound shown below was deposited as a hole transporting layer in a thickness of 45 nm on the hole injection layer 1 by a vacuum deposition method to form a hole transporting layer 2.

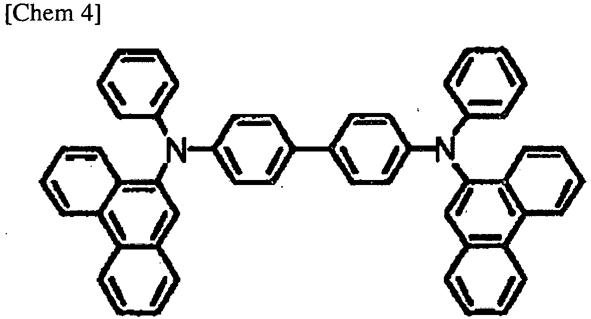

Incidentally, handling was performed in a nitrogen atmosphere or in a vacuum atmosphere form the deposition of the hole transporting layer until completion of the following <9. Encapsulation>, and contact with oxygen or moisture was avoided.

### 7. Light-Emitting Layer

Tris(8-hydroxyquinolinato)aluminum (Alq₃) was formed as a light-emitting layer 3 in a thickness of 60 nm on the hole transporting layer 2 by a vacuum deposition method.

### 8. Formation of Hole Injection Layer and Negative Electrode

A hole injection layer 4 was formed by depositing lithium fluoride (LiF) on the light-emitting layer 3 by a vacuum deposition method so that the thickness became 0.5 nm, and thereafter, aluminum was deposited by a vacuum deposition method so that the thickness became 80 nm to form a negative electrode 5.

### 9. Encapsulation

Subsequently, a sheet-shaped dehydration material 10 was attached to the center of the concave part of a counterbored glass (i.e., glass processed in a concave shape) 11 in a nitrogen globe box, and a photocurable resin 12 was applied to an outer peripheral part of the glass. The counterbored glass 11 was attached to the glass substrate 8 so as to cover the laminate in which the light extraction membrane 7 to the negative electrode 5 had been laminated, and was encapsulated by irradiating only the region on which the photocurable resin had been applied with an ultraviolet light to cure the resin, thereby obtaining an organic electroluminescent element 100 (light-emitting area: 0.36 cm²).

Fig. 5 shows a schematic view of the organic electroluminescent element formed by the above method.

### (Example 26)

On the aforementioned light extraction membrane A was further placed 0.5 ml of an n-butanol diluted solution of an organotitanium oligomer "Orgatix TA-22" manufactured by Matsumoto Fine Chemical Co., Ltd. (TA-22/n-butanol=10/90 (weight ratio)), followed by spin coating (number of rotations at spin coating: 500 rpm for 10 seconds, subsequently 2,000 rpm for 30 seconds). The coated substrate was subjected to pre-drying at 120°C for 2 minutes on a hot plate and subsequently to main drying at 350°C for 30 minutes. Thereafter, the substrate was subjected to natural cooling to obtain a "light extraction membrane B" in which the scattering layer 1, the titanium oxide nano particle layer, and a titanium oxide sol-gel layer were laminated.

The formation of a positive electrode, washing of the substrate, an open bank, a hole injection layer, a hole transporting layer, a light-emitting layer, an electron injection layer, a negative electrode, and encapsulation was conducted according to the method described in Example 25 to obtain an organic electroluminescent element.

### (Comparative Example 8)

An organic electroluminescent element was obtained by the method described in Example 25 except that a glass substrate (glass substrate "OA-10G" manufactured by Nippon Electric Glass Co., Ltd.) was used and a light extraction membrane was not formed.

For the organic electroluminescent elements of Examples 25 and 26 and Comparative Example 8, the thickness of the light extraction membrane, Haze, total light transmittance, surface roughness Ra, ITO etchant resistance (acid resistance), substrate washing resistance, and resist bank preparation suitability were evaluated. Moreover, for each organic electroluminescent element, total luminous flux of an emitted light was measured by the method shown below to evaluate a light extraction magnification. Results are shown in Table 6.

### - Measurement of Thickness, Haze, Total Light Transmittance, and Surface Roughness Ra

In the aforementioned preparation of the organic electroluminescent element, the thickness, Haze, total light transmittance, and surface roughness Ra were measured using the glass substrate on which the light extraction membrane had been formed, before the formation of the positive electrode.

### - Evaluation of ITO Etchant Resistance (acid resistance)

In the aforementioned preparation of the organic electroluminescent element, the glass substrate having the light extraction membrane formed thereon, before the formation of the positive electrode, was dipped in "ITO-02" manufactured by Kanto Chemical Co., Inc. at 25°C for 20 minutes. Thereafter, the glass substrate was washed with water and a degraded state of the surface of the light extraction membrane was visually observed and evaluated according to the following criteria "A" to "C".
A: The surface maintains glossy appearance before test.
B: The glossy appearance of the surface decreases but the membrane remains.
C: The membrane is exfoliated.

### - Evaluation of Substrate Washing Resistance

In the aforementioned preparation of the organic electroluminescent element, a degraded state of the surface of the glass substrate after <Washing of Substrate> was visually observed and evaluated according to the following criteria "A" to "C".
A: The surface maintains glossy appearance before test.
B: The glossy appearance of the surface decreases but the membrane remains.
C: The membrane is exfoliated.

### - Evaluation of Resist Bank Preparation Suitability

In the aforementioned preparation of the organic electroluminescent element, the glass substrate after the formation of the open bank was observed on an optical microscope (5 magnification) and evaluated according to the following criteria "A" to "C".
A: No missing and damage are generated over the entire region of the ITO layer that is a positive electrode.
B: Exfoliation is generated at an edge of the ITO layer that is a positive electrode.
C: Exfoliation of the ITO layer that is a positive electrode is observed over the entire region.

### -Evaluation of Total Luminous Flux of Emitted Light

The total luminous flux [lumen (lm)] at the time of light emission by imparting 4.0 mA of direct current to the obtained organic electroluminescent element was measured by an integrating sphere type total luminous flux measuring system manufactured by Labsphere (integrating sphere: SLMS-1011 Model, diode array spectroscope: DAS-1100 Model).

### - Evaluation of Light Extraction Magnification

A value obtained by dividing the total luminous flux of each organic electroluminescent element by the total luminous flux of the organic electroluminescent element using a substrate having no light extraction membrane (Comparative Example 8) was calculated as a "light extraction magnification".

As shown in Table 6, a total luminous flux of 1.51 times at the maximum was obtained in the case of the organic electroluminescent elements in which the scattering layer of the invention was used as a light extraction membrane as compared with the case where the light extraction membrane was not used and thus an improvement of light extraction efficiency was observed.

**[Table 6]**

| | Layer constitution of light extraction membrane | | | Physical properties of light extraction membrane | | | | | | | Evaluation results of organic electroluminescent element | |
|---|---|---|---|---|---|---|---|---|---|---|---|---|
| | | | | Total thick-ness (um) | Haze | Total light transmittance (%) | Surface roughness Ra (nm) | ITO etchant liquid resistance | Substrate washing resistance | Resist bank preparation suitability | Total luminous flux (m lm) | Light extraction magnification |
| | First layer | Second layer | Third layer | | | | | | | | | |
| Example 25 (*) | Scattering layer 1 | Titanium oxide nano-particle layer | none | 1.64 | 78.9 | 73.1 | 7.7 | A | A | B | 48.56 | 1.26 times |
| Example 26 (*) | Scattering layer 1 | Titanium oxide nano-particle layer | Titanium oxide sol-gel layer | 1.70 | 76.4 | 70.8 | 3.8 | A | A | A | 58.39 | 1.51 times |
| Comparative Example 8 (*) | none | none | none | - | 0.0 | 91.8 | 0.2 | A | A | A | 38.55 | 1.00 time |

| | | | | | | | | | | | | |
|---|---|---|---|---|---|---|---|---|---|---|---|---|
| (*) Not according to the invention | | | | | | | | | | | | |

### (Example 27)

### 1. Preparation of Substrate

There was prepared a substrate (hereinafter it is referred to as ITO substrate for element 2 mm square) obtained by membrane formation of ITO having a thickness of 70 nm as a positive electrode on a glass substrate "OA-10G" (37.5 mm*25 mm*0.7 mm thick) manufactured by Nippon Electric Glass Co., Ltd. and subjecting ITO to patterning so that light emission area became 2 mm square.

A scattering layer 1 was formed by the method described in Example 1 on a surface (light-emitting surface) opposite to the surface of the substrate on which the ITO membrane had been formed.

Next, the washing step described in "3. Washing of Substrate" was performed.

Furthermore, the formation of a hole injection layer, a hole transporting layer, a light-emitting layer, an electron injection layer, a negative electrode, and encapsulation was conducted according to the method described in Example 10 to obtain an organic electroluminescent element 2 mm square in which the scattering layer 1 was formed at the light-emitting surface side (light emission area: 0.04 cm²).

### (Examples 28 to 31, Comparative Example 9)

Organic electroluminescent elements in which the scattering layer 1 was formed at the light-emitting surface side (Examples 28 to 31) were obtained according to the method of Example 27 except that the scattering layer 1 was changed to the scattering layers described in Table 7, respectively. In addition, there was obtained an organic electroluminescent element in which no scattering layer was formed (Comparative Example 9).

**[Table 7]**

| | Light extraction membrane | | Evaluation results of organic electroluminescent element | |
|---|---|---|---|---|
| | | Substrate washing resistance | Total luminous flux | Light extraction magnification |
| | | | (m lm) | |
| Example 27 (*) | Scattering layer 1 | A | 56.5 | 1.23 times |
| Example 28 | Scattering layer 25 | A | 54.6 | 1.19 times |
| Example 29 (*) | Scattering layer 13 | A | 58.0 | 1.27 times |
| Example 30 (*) | Scattering layer 15 | A | 53.1 | 1.16 times |
| Example 31 | Scattering layer 30 | A | 53.3 | 1.16 times |
| Comparative Example 9 (*) | none | A | 45.8 | 1.00 time |

| | | | | |
|---|---|---|---|---|
| (*) Not according to the invention | | | | |

A total luminous flux at the time of light emission by imparting 4.0 mA of direct current to each of the obtained organic electroluminescent elements was measured. As shown in Table 7, a total luminous flux of 1.27 times at the maximum was obtained in the case of the organic electroluminescent elements in which the scattering layer 1 was formed at the light-emitting surface side as compared with the element in which the layer was not formed (Comparative Example 9). Even in the case where the light scattering layer of the invention is formed at the light-emitting surface side, an improvement of light extraction efficiency was observed.

### (Example 32) (Not according to the invention)

### <Evaluation of Flexibility of Scattering Membrane>

The scattering layer coating liquid described in Example 1 was applied on a polyimide film (50 mm*50 mm*0.7 mm thick) having flexibility by spin coating (number of rotations at spin coating: 500 rpm for 10 seconds, subsequently 1,000 rpm for 30 seconds). The coated substrate was subjected to pre-drying at 120°C for 2 minutes on a hot plate and subsequently to main drying at 220°C for 30 minutes. Thereafter, the substrate was subjected to natural cooling to obtain a polyimide film on which a scattering membrane was formed.

The polyimide film was wound on a stainless steel rod having a diameter of 5 mm so that the scattering membrane came outside. A SEM sample was cut out of the polyimide film after winding and a surface image of the scattering membrane was observed. The formation of voids was confirmed on the surface of the scattering membrane but exfoliation from the polyimide film and cracks on the scattering membrane were absent, so that any defects of the scattering membrane which might be caused by the winding treatment were not confirmed at all.

Moreover, the surface of the scattering membrane was visually observed after the winding treatment was repeated 50 times but no defect was confirmed.

From the above results, it was found that the scattering membrane of the invention has an excellent flexibility and is also applicable to a flexible substrate material having flexibility. The scattering membrane of the invention can be used as a membrane that improves light extraction efficiency, also in an organic electroluminescent element using a flexible substrate material having flexibility.

While the invention has been described in detail and with reference to specific embodiments thereof, it will be apparent to one skilled in the art that various changes and modifications can be made therein without departing from the spirit and scope thereof. The present application is based on Japanese Patent Application No. 2012-001989 filed on January 10, 2012, and the contents are incorporated herein by reference.

### Description of Reference Numerals and Signs

- 1: Hole injection layer
- 2: Hole transporting layer
- 3: Light-emitting layer
- 4: Electron injection layer
- 5: Negative electrode
- 6: Positive electrode (ITO)
- 7: Scattering membrane (light extraction membrane)
- 8: Substrate (glass substrate)
- 9: Open bank (bank material)
- 10: Sheet-shaped dehydration material
- 11: Counterbored glass
- 12: Photocurable resin
- 100: Organic electroluminescent element

## Claims

1. A coating composition comprising a polysilane compound, a metal oxide, a solvent and a compound having a carbamate structure.

2. The coating composition according to claim I, wherein the compound having a carbamate structure is a dispersing agent.

3. The coating composition according to claim 1 or 2, wherein the metal oxide is at least one selected from zinc oxide, titanium oxide, barium titanate, tantalum oxide, silicon oxide, aluminum oxide, zirconium oxide, cerium oxide, and tin oxide.

4. The coating composition according to any one of claims 1 to 3, wherein a refractive index of the metal oxide is 2.0 or more.

5. The coating composition according to any one of claims 1 to 4, wherein an average particle diameter of the metal oxide is 1,000 µm or less.

6. The coating composition according to any one of claims 1 to 5, wherein the polysilane compound is a silicon network polymer represented by the general formula (2):
(R²Si)ₙ (2)
wherein R² is the same or different from each other and represents a hydrogen atom, an alkyl group, an alkenyl group, an arylalkyl group, an aryl group, an alkoxy group, a hydroxyl group, a phenolic hydroxyl group, or an amino group; n is an integer of 4 to 10,000.

7. A porous membrane obtained by curing the coating composition according to any one of claims 1 to 6.

8. A light scattering membrane obtained by curing the coating composition according to any one of claims 1 to 6.

9. An organic electroluminescent element comprising the light scattering membrane according to claim 8.

10. The organic electroluminescent element according to claim 9, wherein the light scattering membrane is arranged between a substrate and a positive electrode.

11. The organic electroluminescent element according to claim 10, wherein the substrate is a flexible substrate having flexibility.

12. An organic EL display device comprising the organic electroluminescent element according to any one of claims 9 to 11.

13. An organic EL lighting comprising the organic electroluminescent element according to any one of claims 9 to 11.

14. A method for manufacturing a porous membrane, the method comprising: applying the coating composition according to any one of claims 1 to 6 on a substrate; and removing the solvent.

## Patentansprüche

1. Beschichtungszusammensetzung, umfassend eine Polysilanverbindung, ein Metalloxid, ein Lösungsmittel und eine Verbindung mit einer Carbamatstruktur.

2. Beschichtungszusammensetzung nach Anspruch 1, wobei die Verbindung mit einer Carbamatstruktur ein Dispergiermittel ist.

3. Beschichtungszusammensetzung nach Anspruch 1 oder 2, wobei das Metalloxid mindestens eines ist, gewählt aus Zinkoxid, Titanoxid, Bariumtitanat, Tantaloxid, Siliciumoxid, Aluminiumoxid, Zirkoniumoxid, Ceroxid und Zinnoxid.

4. Beschichtungszusammensetzung nach mindestens einem der Ansprüche 1 bis 3, wobei ein Brechungsindex des Metalloxids 2,0 oder mehr beträgt.

5. Beschichtungszusammensetzung nach mindestens einem der Ansprüche 1 bis 4, wobei ein durchschnittlicher Teilchendurchmesser des Metalloxids 1000 µm oder weniger beträgt.

6. Beschichtungszusammensetzung nach mindestens einem der Ansprüche 1 bis 5, wobei die Polysilanverbindung ein Siliciumnetzwerkpolymer ist, wiedergegeben durch die allgemeine Formel (2):
(R²S1)ₙ (2)
worin R² gleich oder voneinander verschieden ist und ein Wasserstoffatom, eine Alkylgruppe, eine Alkenylgruppe, eine Arylalkylgruppe, eine Arylgruppe, eine Alkoxygruppe, eine Hydroxylgruppe, eine phenolische Hydroxylgruppe oder eine Aminogruppe bedeutet; n eine ganze Zahl von 4 bis 10000 ist.

7. Poröse Membran, erhalten durch Härten der Beschichtungszusammensetzung gemäß mindestens einem der Ansprüche 1 bis 6.

8. Lichtstreuungsmembran, erhalten durch Härten der Beschichtungszusammensetzung gemäß mindestens einem der Ansprüche 1 bis 6.

9. Organisches Elektrolumineszenzelement, umfassend die Lichtstreuungsmembran gemäß Anspruch 8.

10. Organisches Eleketrolumineszenzelement nach Anspruch 9, wobei die Lichtstreuungsmembran zwischen einem Substrat und einer positiven Elektrode angeordnet ist.

11. Organisches Elektrolumineszenzelement nach Anspruch 10, wobei das Substrat ein flexibles Substrat mit Flexibilität ist.

12. Organische EL-Anzeigevorrichtung, umfassend das organische Elektrolumineszenzelement nach mindestens einem der Ansprüche 9 bis 11.

13. Organische EL-Beleuchtung, umfassend das organische Elektrolumineszenzelement nach mindestens einem der Ansprüche 9 bis 11.

14. Verfahren zur Herstellung einer porösen Membran, wobei das Verfahren umfasst: Aufbringen der Beschichtungszusammensetzung nach mindestens einem der Ansprüche 1 bis 6 auf ein Substrat; und Entfernen des Lösungsmittels.

## Revendications

1. Une composition de revêtement comprenant un composé de polysilane, un oxyde de métal, un solvant et un composant ayant une structure de carbamate.

2. La composition de revêtement selon la revendication 1, dans laquelle le composé ayant une structure de carbamate est un agent de dispersion.

3. La composition de revêtement selon la revendication 1 ou 2, dans laquelle l'oxyde de métal est au moins choisi parmi l'oxyde de zinc, l'oxyde de titane, le titanate de baryum, l'oxyde de tantale, l'oxyde de silice, l'oxyde d'aluminium, l'oxyde de zirconium, l'oxyde de cérium et l'oxyde de tin.

4. La composition de revêtement selon l'une quelconque des revendications 1 à 3, dans laquelle l'indice de réfraction de l'oxyde de métal est 2,0 ou plus.

5. La composition de revêtement selon l'une quelconque des revendications 1 à 4, dans laquelle un diamètre de particule moyen de l'oxyde de métal est 1,000 µm ou moins.

6. La composition de revêtement selon l'une quelconque des revendications 1 à 5, dans laquelle le composé de polysilane est un polymère réticulé de silicone représenté par la formule (2) générale:
(R²Si)ₙ (2)
dans laquelle R² est le même ou différent l'un de l'autre et représente un atome d'hydrogène, un groupe d'alkyle, un groupe d'alkényle, un groupe d'arylalkyle, un groupe d'aryle, un groupe alkoxy, un groupe hydroxyle, un groupe hydroxyle phénolique, ou un groupe amino; n est un nombre entier de 4 à 10.000.

7. Une membrane poreuse obtenue par polymérisation de la composition de revêtement selon l'une quelconque des revendications 1 à 6.

8. Une membrane diffusant de la lumière obtenue par polymérisation de la composition de revêtement selon l'une quelconque des revendications 1 à 6.

9. Un élément électroluminescent organique comprenant la membrane diffusant de la lumière selon la revendication 8.

10. L'élément électroluminescent organique selon la revendication 9, dans lequel la membrane diffusant de la lumière est arrangée entre un support et une électrode positive.

11. L'élément électroluminescent organique selon la revendication 10, dans lequel le support est un support flexible ayant de la flexibilité.

12. Un dispositif d'affichage EL organique comprenant l'élément électroluminescent organique selon l'une quelconque des revendications 9 à 11.

13. Un éclairage EL organique comprenant l'élément électroluminescent organique selon l'une quelconque des revendications 9 à 11.

14. Un procédé pour fabriquer une membrane poreuse, le procédé comprenant: l'application de la composition de revêtement selon l'une quelconque des revendications 1 à 6 sur un support; et l'enlèvement du solvant.
